# EUROPEAN PATENT SPECIFICATION

(11) **EP 2 823 092 B1**
(45) Date of publication and mention of the grant of the patent: **21.11.2018**
(21) Application number: 13709510.5
(22) Date of filing: 01.03.2013
(51) Int. Cl.: C30B 7/00, C30B 29/16, C30B 29/46, C30B 29/60, C30B 33/02, H01L 21/02, C30B 7/10, C30B 7/14, C30B 29/22, H01G 9/20, H01L 51/42, H01L 31/032, H01L 31/18

(54) **MESOPOROUS SINGLE CRYSTAL SEMICONDUCTORS**
MESOPORÖSE EINKRISTALLHALBLEITER
SEMI-CONDUCTEURS MONOCRISTALLINS MÉSOPOREUX

(30) Priority: 05.03.2012 GB 201203881
(43) Date of publication of application: 14.01.2015
(73) Proprietor: Oxford University Innovation Limited, Botley Oxford OX2 0JB (GB)
(72) Inventor: SNAITH, Henry James, Oxford Oxfordshire OX1 3PU (GB); CROSSLAND, Edward James William, Oxford Oxfordshire OX1 3PU (GB)
(74) Representative: J A Kemp
(86) International application number: PCT/GB2013/050518
(87) International publication number: WO 2013/132236

(56) References cited:
- CN-A- 102 079 542
- CN-B- 101 388 292
- US-A1- 2003 157 248
- KARTINI I ET AL: "Hydrothermal seeded synthesis of mesoporous titania for application in dye-sensitised solar cells (DSSCs)", JOURNAL OF MATERIALS CHEMISTRY 20041007 ROYAL SOCIETY OF CHEMISTRY GB, vol. 14, no. 19, 7 October 2004 (2004-10-07), pages 2917-2921, XP002706082, DOI: 10.1039/B406286H cited in the application
- BIAN Z ET AL: "Single-crystal-like titania mesocages", ANGEWANDTE CHEMIE - INTERNATIONAL EDITION 20110201 WILEY-VCH VERLAG DEU, vol. 50, no. 5, 1 February 2011 (2011-02-01), pages 1105-1108, XP002706083, DOI: 10.1002/ANIE.201004972 cited in the application
- ZHANG D ET AL: "A micrometer-size TiO2 single-crystal photocatalyst with remarkable 80% level of reactive facets", CHEMICAL COMMUNICATIONS 2009 ROYAL SOCIETY OF CHEMISTRY GBR, no. 29, 2009, pages 4381-4383, XP002706084, ISSN: 1359-7345 cited in the application

## Description

### FIELD OF THE INVENTION

The invention relates to mesoporous single crystals of a semiconductor, and a process for producing such mesoporous single crystals. The invention also relates to semiconducting layers and semiconducting devices comprising the mesoporous single crystals.

### BACKGROUND TO THE INVENTION

High surface area ceramic materials are an important component in photovoltaic and light-emitting devices. Current state-of-the-art mesoporous semiconductor electrodes (e.g. metal oxides for dye-sensitized solar cells (DSSC) type cells) are made from thermal sintering of preformed nanocrystals approximately 20 nm in size. The mesoscale pore structure is necessary to provide high area for surface dye-loading, or to increase the contact area between n- and p-type semiconductors in a bulk heterojunction layer. However, using a nanoparticle methodology the crystal domain size is strictly coupled to the particle size as grain boundaries exists at interparticle connections. Crystalline defects act as charge trapping sites for electrons under photovoltaic operation and reduce charge diffusion and efficiency of collection at an electrode.

Strategies for the synthesis of mesoporous inorganic semiconductors have been reported in which precursors (small molecules or nm-scale nanocrystals) of the target material are mixed with structure-directing agents (e.g. surfactants, block copolymers) or infiltrated into porous templates followed by thermal sintering to induce crystallization. However in all of these cases the material produced has a high internal defect density and nanometer scale crystal grains.

The synthesis of (non-porous) micron-sized TiO₂ single crystals from TiF₄ precursors was first reported in 2008 by Yang et al. (Yang et al., Nature 453(7195), 638-641 (2008) Anatase single crystals with a large percentage of reactive facets). There now exist numerous modifications of this recipe using different additives and reaction conditions. For example, the route used by Zhang et al. (Zhang et al., ChemComm. 2009 (29), 4381 A micrometer-size TiO₂ single-crystal photocatalyst with remarkable 80% level of 001 facets). A review of synthetic routes to non-templated TiO₂ has been published by Liu et al (Liu et al. Chem Mater 2011, 23, 4085-4093 Anatase TiO₂ with dominant high energy {001} facets: synthesis, properties and applications).

The idea of using seed crystals in order to achieve growth below the nucleation barrier is known. Take for example routes to growing single, large inorganic crystal ingots or nanorods grown from nanocrystal seeds (Jana J Phys Chem 2001, 105, 4065-4067 Wet chemical synthesis of high aspect ratio cylindrical gold nanorods). With regard to TiO₂, Tartaj reported the use of 12 nm "seed crystals" included in the synthesis of 100 nm TiO₂ "mesocrystals" grown inside a water-oil microemulsion (ChemComm. 2011 47, 256-258). The purpose of the seeds was to encourage crystallization of the anatase phase at low enough temperatures to maintain the integrity of the soft template.

Kartini et al. (Kartini J Mat Chem 2004, 14, 2917-2921 Hydrothermal seeded synthesis of nanoporous titania for application in DSCs) reported the use of anatase TiO₂ seed crystals mixed with a block copolymer structure director. In this case the seed crystals were included only to preferentially aggregate into one phase of the self-assembled copolymer morphology.

Lassinantti et al. (Lassinantti Micro and Mesoporous Mater 38 (2000) 25-34 Faujasite type films synthesised by seeding) showed that continuous Faujasite-type zeolite films can be seeded on an α-alumina surface by first coating the layer with crystal seeds. ZnO nanowire films also rely on a surface coating of ZnO seed crystals to nucleate growth of nanowire arrays (e.g. Tian Nature Materials 2003 Complex and oriented ZnO nanostructures).

US 2008/0248304 discloses the use of nanocrystals bound to a substrate used to promote growth of a metal nanowire.

There exist reports describing the synthesis of 'mesocrystals' which are defined as crystals whose elemental units are nanocrystals that attach to each other with a common crystallographic orientation. Bian et al. (Angw Chem 2011, 50, 1105-1108 Single-Crystal-like Titania Mesocages) for example reported "single-crystal-like" titania which forms from oriented attachment of pre-formed nanoparticles inside the pores of a guiding template. An electron beam diffraction pattern of a single particle of such a mesocrystal produces a Laue Pattern, the reciprocal lattice pattern characteristic of the atomic crystal lattice, with a common orientation with respect to the electron beam. In a polycrystalline material in which the crystalline domains have random orientation only rings are visible in the diffraction pattern. Despite this observation, the external shapes of the particles thus formed are spherical or irregular, rather than following the faceted symmetry of the underlying crystal, as is the case for non-porous single crystals. The width of the peaks in the X-ray diffraction pattern of this material shows broadening indicative of domain sizes in the 10 nm regime, reflecting the makeup of the material from nanoscale building blocks that have common orientation, but not atomic coherence beyond the 10 nm scale. This distinction is clearly stated by Bian et al. who refer to this material as "single-crystal-like" and by Dickinson et al. (Chem Mater. 2006, 18, 3088-3095) who describe SAED patterns and HRTEM images of Cr₂O₃ and Co₃O₄ porous crystals as supporting the observation that "all the parts (nanorods) in the particles have the same crystal orientation." However this distinction is not made clear in other publications (e.g. Yue et al. Chem Mater, 2009, 21, 2540-2546) for the rutile phase of TiO₂. Other mesocrystals patterned in this way include In₂O₃ (Yue J Mater. Chem. 2007, 17, 4947-4952), NiO (Yue J Mater. Chem. 2007, 17, 4947-4952), Mn₂O₃ (Yue J Mater. Chem. 2007, 17, 4947-4952), CeO₂ (Yue J Mater. Chem. 2007, 17, 4947-4952), WO₃ (Yue J Mater. Chem. 2007, 17, 4947-4952), Fe₂O₃ (Yue J Mater. Chem. 2007, 17, 4947-4952), MnO₂ (Yue J Mater. Chem. 2007, 17, 4947-4952).

In US 2006/0249075 a porous silicon film is obtained by etching holes into a single-crystal silicon substrate. In WO 95/15280 a porous silicon film is obtained by surface treatment of a single-crystal substrate.

Mesoporous materials have also been disclosed in patent applications US 2006/0257321, US 2003/0157248, US 2011/0189071

Some literature reports using porous templates mention "single-crystals" that refers to the domain size of the periodic structures at the 5-10 nm scale present in the template. See for example Gu et al. (Gu Chem Mater 2010, 22, 4828-4833 Growth of single crystal mesoporous carbons with im3m symmetry).

There is an ongoing need to provide improved semiconducting materials which not only have a high surface area, for surface dye-loading or to provide a high contact area between n-and p-type semiconductors, but also crystal domain size which significantly exceeds the pore size in order to deliver a high charge mobility for improved device efficiency.

### SUMMARY OF THE INVENTION

The present inventors have developed a technology capable of nucleating and growing single-domain crystals inside any desired porous template. They have found that a key strategy for producing single crystals of semiconducting materials with an internal mesoscale porosity is to combine the mesostructure of the template with long-range atomic order characteristic of single-crystals. Using mesoporous single crystals the atomic domain size is decoupled from the mesoscale porous morphology, and can be extended far beyond the characteristic pore size.

The present inventors have produced mesoporous semiconductor crystals in which the crystal domain size can be controlled from at least 50 nm, extending up to several orders of magnitude greater. The aim of such a material is to achieve crystals with extremely large accessible surface area without introducing atomic scale defects in the crystal bulk that are believed to hinder the transport of charge over distances much greater than the characteristic pore size by acting as adjoined electronic trapping sites and scattering sites. Such materials thus are expected to combine high exposed surface area with very high charge mobility. In addition, primary crystallization and mesopore formation can be complete before film deposition, thus decoupling high temperature processing from photovoltaic device manufacture.

In such a material the presence of surface defects and associated electronic sites is decoupled from the existence of equivalent bulk sites. Since the entire internal surface of the mesoporous single crystal is accessible, these surface sites can be treated chemically for example by deposition of heterogeneous shell materials that could act to introduce or passivate electronic surface states, thus giving complete control over the density and location of electronic sites in the crystal.

Accordingly, the invention provides a process for producing a mesoporous single crystal of a semiconductor, wherein the shortest external dimension of said single crystal, measured along any of the crystallographic principal axes of said crystal, is x, wherein x is equal to or greater than 50 nm, and wherein the process comprises: providing a mesoporous template material, the mesoporous template material comprising a material comprising pores; producing a seeded mesoporous template material which comprises a seed crystal of the semiconductor disposed in a pore of the mesoporous template material, by growing said seed crystal in the mesoporous template material; and subsequently growing a single crystal of the semiconductor within the seeded mesoporous template material until said shortest external dimension of the single crystal is x.

Usually, the volume of said single crystal is y, wherein y is equal to or greater than 1.25x10⁵ nm³, and the process comprises growing said single crystal within the mesoporous template material until the volume of said single crystal is y.

Further provided is a mesoporous single crystal of a semiconductor, wherein the shortest external dimension of said single crystal, measured along any of the crystallographic principal axes of said crystal, is x, wherein x is equal to or greater than 50 nm.

Further provided is a mesoporous single crystal of a semiconductor, wherein the volume of said single crystal is y, wherein y is equal to or greater than 1.25x10⁵ nm³

The invention also provides a composition which comprises a plurality of mesoporous single crystals of the invention.

The invention also provides a semiconducting layer which comprises a plurality of mesoporous single crystals of the invention.

In another aspect, the invention provides a semiconducting device which comprises at least one layer that comprises a mesoporous single crystal of the invention.

### BRIEF DESCRIPTION OF THE FIGURES

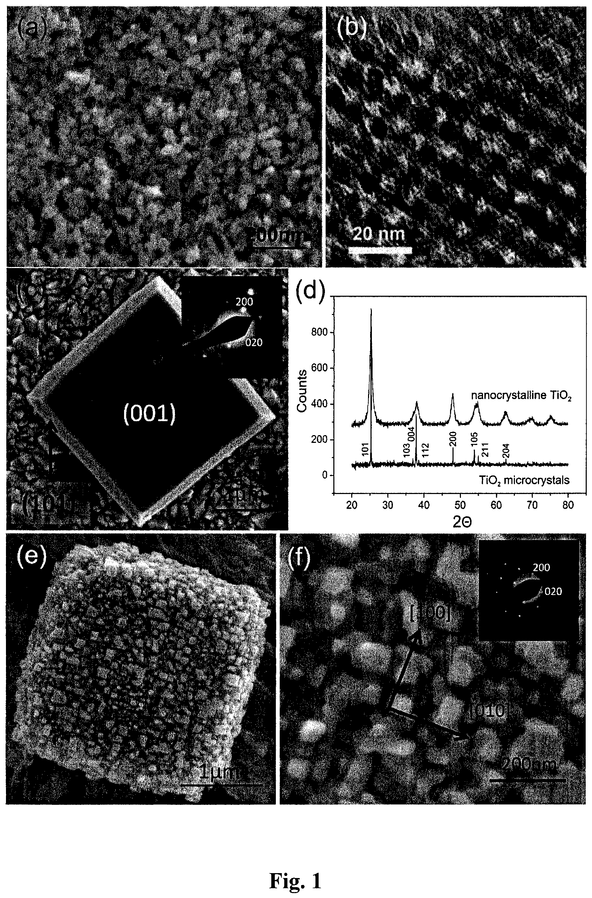

Figure 1 shows a comparison of mesoporous semiconductor crystals with previous state-of-the-art mesoporous TiO₂. (a) a mesoporous ceramic "sponge" made by thermal sintering of 25nm anatase nanoparticles at 500°C. (b) oriented attachement of 10nm TiO₂ nanocrystallites within the pores of a guiding silica template, (c) synthesis of TiO₂ single domain microcystals. with typical truncated bipyramidal anatase TiO₂ faceted form produced by hydrolysis of 20mM TiF₄ at 210 °C. Inset is the electron diffraction pattern from a single crystal which can be indexed to the [001] zone axis of anatase TiO₂. (d) Anatase XRD pattern of the sample in (c). (e) Mesoporous TiO₂ microcrystal (after template removal) synthesized under identical conditions to (c) however now replicating the pore structure of a 50nm silica bead template, (d) magnified image of the mesoscale porous morphology of the crystal in (c) with the electron diffraction of the complete crystal inset.

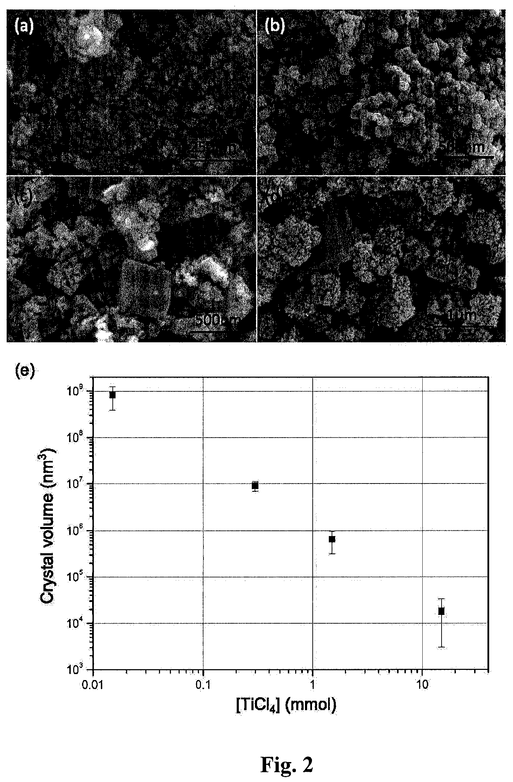

Figure 2 shows the control of mesoporous TiO₂ crystal dimension via number density of crystal nuclei introduced into the reaction vessel, (a-d) Representative truncated bipyramidal anatase TiO₂ microcrystals (after template removal) produced by hydrolysis of 20mM TiF₄ at 210 °C in 650 mg of a silica template pre-treated for 60 min at 70°C in TiCl₄(aq) with concentration of 15 mM, 1.5 mM, 150 µM and 15 µM respectively, (e) Mean external (geometric) volume of crystals in (a) to (d).

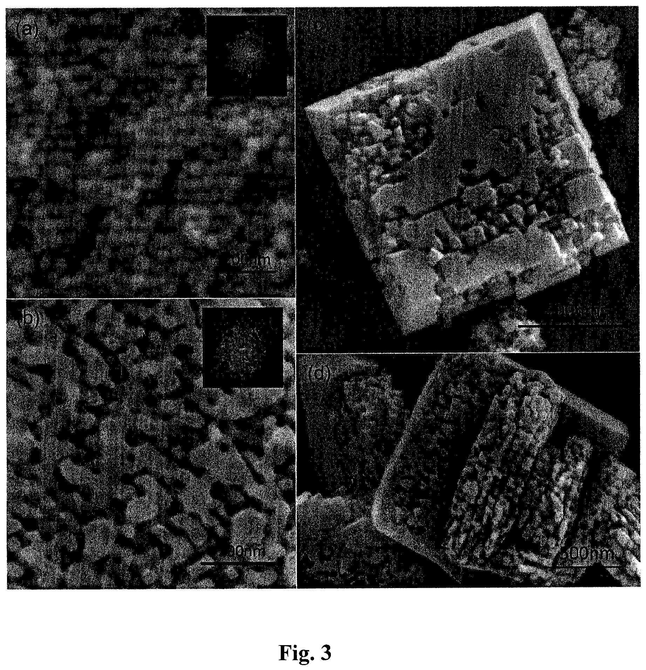

Figure 3 shows the high fidelity mesoscale replication within faceted mesoporous single crystal anatase TiO₂. (a) Pristine silica template made up of quasi close-packed 50nm silica beads (FFT inset 49±3nm with hexagonal close-packed symmetry), (b) mesoscale pore structure at the (100) surface of TiO₂ crystals synthesized inside the template in (a) at 170°C, 40mM TiF₄ shows close to perfect replication of the template voids (FFT inset 47±3nm with hexagonal close-packed symmetry), (c) TiO₂ crystals that nucleate near the surface of the silica template continue to grow out of the confines of the pores, resulting in non-porous areas coexisting with porous areas within a single microcrystal. When this happens the single-domain nature of the microcrystal is evident as the compact-region growth front from distant pores meet and follow the faceted contours expected from the single underlying anatase crystal symmetry. Reaction conditions are (c) 210°C 20mM and (d) 170°C 20mM.

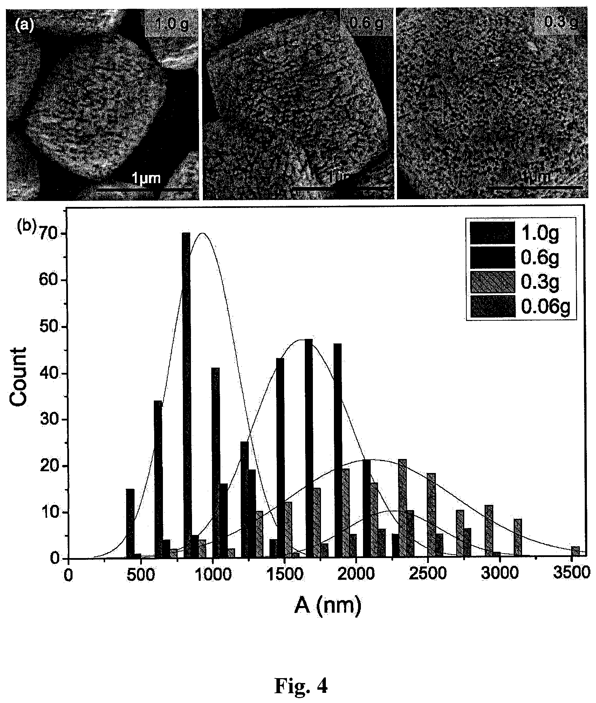

Figure 4 shows the mesoporous crystal morphology evolution with increasing volume of pre-treated silica template, (a) SEM images of representative truncated bipyramidal anatase TiO₂ microcrystals (after template removal) synthesized at 130°C 120 mM in 50 ml reaction vessels containing the stated mass of silica template (15 µM TiCl₄ template pretreatment). (b) Crystal size (A) distributions for the samples in (a).

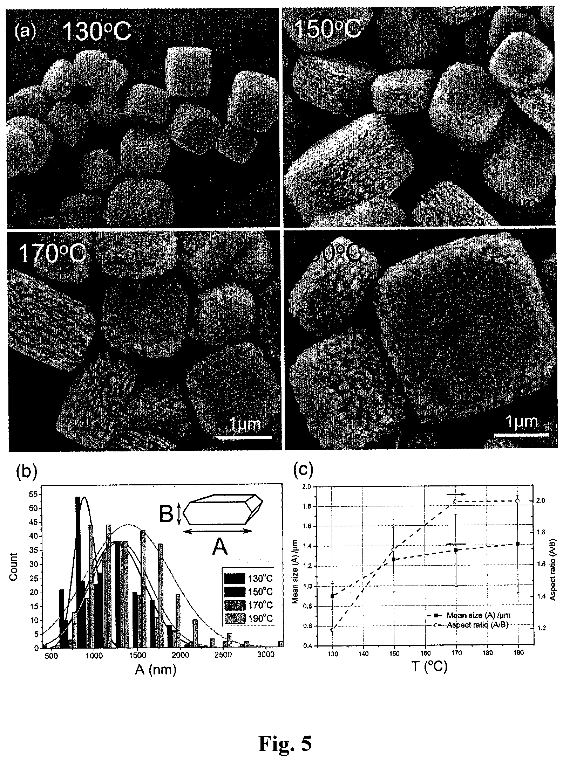

Figure 5 shows the effect of reaction temperature on mesoporous crystal dimension (40 mM initial TiF₄ concentration), (a) Representative truncated bipyramidal anatase TiO₂ microcrystals (after template removal) synthesized at the stated reaction temperature for 12 h (15 µM TiCl4 template pretreatment). (b) Population distribution of microcrystal dimension size (A) as a function of reaction temperature, (c) Mean dimension (A) and aspect ratio of the populations in (b), the size distribution (standard deviation) becomes narrower with decreasing reaction temperature. As depicted in Figure 5, the dimension B is the shortest external dimension of said single crystal.

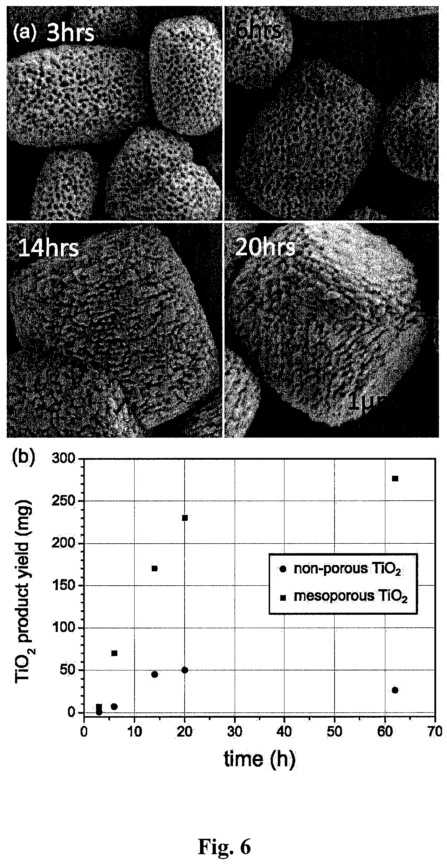

Figure 6 shows the morphological evolution of mesoporous TiO₂ mesoporous crystals with time at 130°C (120 mM TiF₄). (a) Representative truncated bipyramidal anatase TiO₂ mesoporous crystals (after template removal) after the stated reaction temperature (15 µM TiCl₄ template pretreatment). (b) Mass of TiO₂ crystals produced after time t.

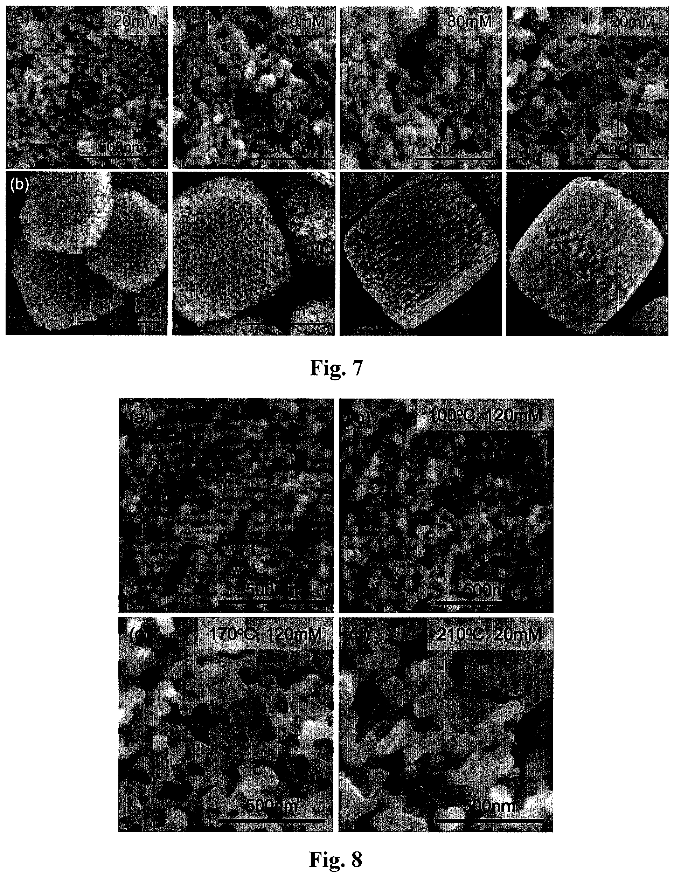

Figure 7 shows the loss of mesoscale porosity in the TiO₂ mesoporous crystals caused by template etching, (a) Morphology of mesoporous TiO₂ microcrystals after 12 h reaction at 130°C with the stated initial TiF₄ concentration, (b) Morphology of the (50 nm silica bead) template corresponding to the reaction times in (a), observed in regions of the template where no crystallization took place. Surface porosity of the crystals is noticeably degraded at TiF₄ concentrations above 80 mM under these conditions.
Figure 8 shows the degradation of the silica template with increasing reaction temperature, (a) Pristine template (quasi close-packed 50nm diameter silica beads), (b) After reaction at 100°C, 120mM TiF₄ for 62 h no significant change is visible in the bead structure, (c) After 12 h at 170°C, 120mM TiF₄ the template shows significant coarsening caused by HF etching of silica, (d) After 12 h at 210°C the coarsening is even more severe, even at low (20 mM) TiF₄ concentration (i.e. low concentration HF production).

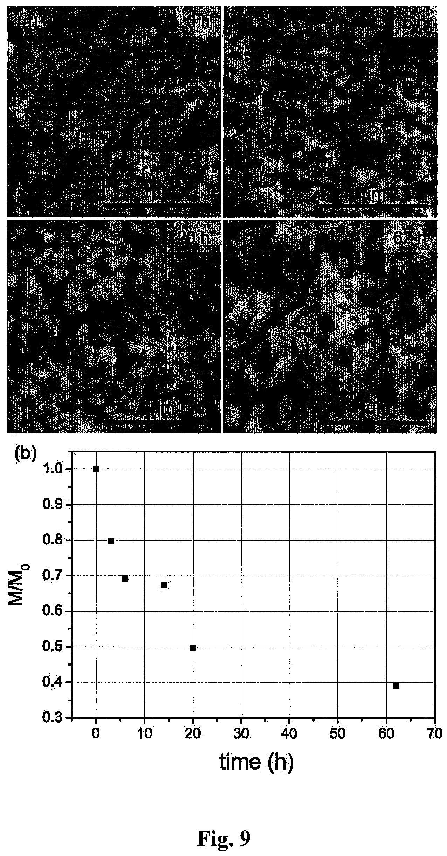

Figure 9 shows the degradation of silica template with reaction time at 130°C, 120 mM initial TiF₄ concentration, (a) Pristine template (quasi close-packed 50 nm diameter silica beads), and the evolution of template structure after the stated reaction time in hours. (b) Normalised mass loss (M/Mo) of the templates in (a).

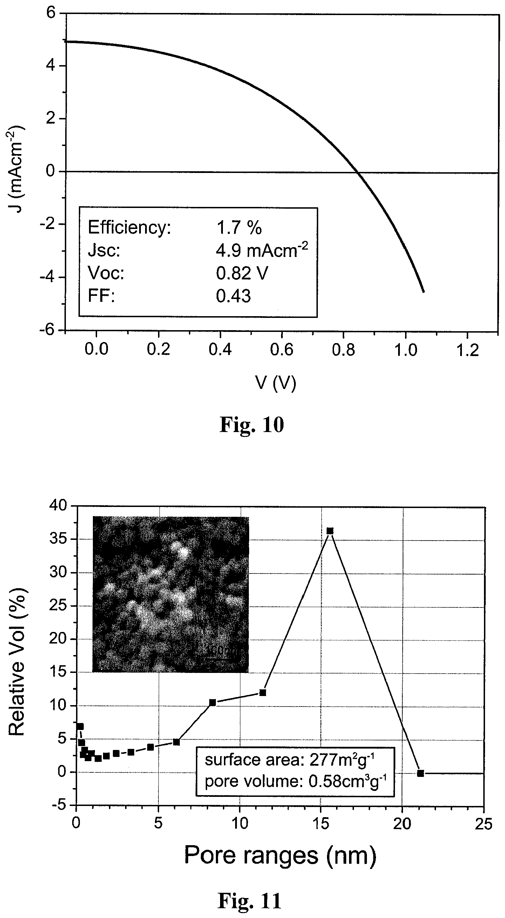

Figure 10 shows a Current-Voltage curve from the prototype solar cells made using active electrode layers formed from 50 nm silica bead-patterned mesoporous TiO₂ single crystals synthesized at 130°C from a 120 mM TiF₄ solution. The crystals were processed into a layer from a screen-printable paste containing a cellulose binder. The electrodes were light-sensitized with a surface-adsorbed organic indolene dye before infiltration with an organic hole transporting material (spiro-ometad) and capped with a silver electrode.
Figure 11 shows the pore distribution of a pristine, quasi close-packed 30 nm diameter silica bead template (SEM inset) as determined by BET analysis of nitrogen adsorption-desorption isotherms. The surface area of the 30nm bead template is 277 m²g⁻¹, with a pore volume of 0.58 cm³g⁻¹ and pore distribution peak at approximately 15 nm.

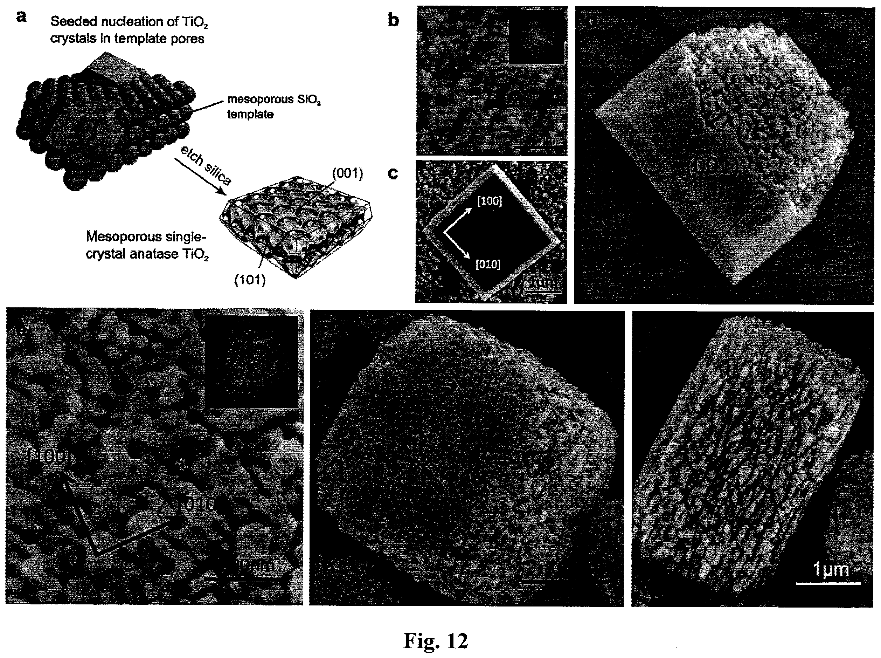

Figure 12 shows: (a) a schematic illustration of the removal of the template material by selective etching in NaOH (aq), to recover the mesoporous TiO2 crystal product; (b) SEM of the pristine silica template made up of quasi close-packed silica beads (Fast Fourier Transform (FFT) inset giving 49 +/- 3nm 6-fold symmetry); (c) SEM of a homogeneously nucleated bulk crystal; and (d) to (g) SEM characterisation of the mesoporous TiO₂ crystal product, including (d) a crystal which grew from a seed located on or close to an external surface of the mesoporous template; (e) the mesoscale detail of a portion of that crystal which grew within the template; and (f) and (g) crystals grown entirely within the template pores.

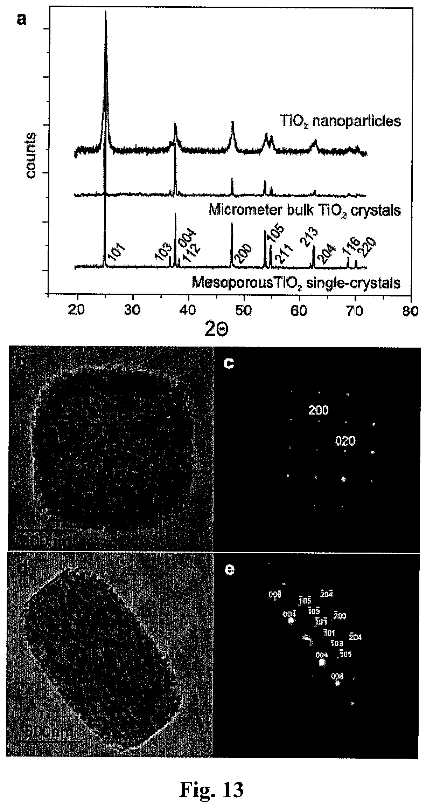

Figure 13 shows, in Figure 13a, the XRD patterns of: (i) an ensemble of the mesoporous TiO₂ single crystals of the invention (lower trace), (ii) nontemplated solid anatase microcrystals (middle trace), and (iii) a standard mesoporous anatase TiO₂ nanoparticle film (upper trace; Dyesol DSL 18NR-T, 20 nm average particle size). Figures 13b-e show the results of electron diffraction taken from complete mesoporous particles, producing the Laue diffraction patterns shown that are indexed to anatase TiO₂ with beam orientation consistent with the crystal symmetry of the Wulff construction. The distinct crystal shapes in Figure 13b and d result from different reaction temperatures. Taken together with SEM characterisation of particle size and symmetry, these results are entirely consistent with the mesoporous particles comprising a single underlying anatase crystal domain, with missing internal volume defined by the mesoporous template.

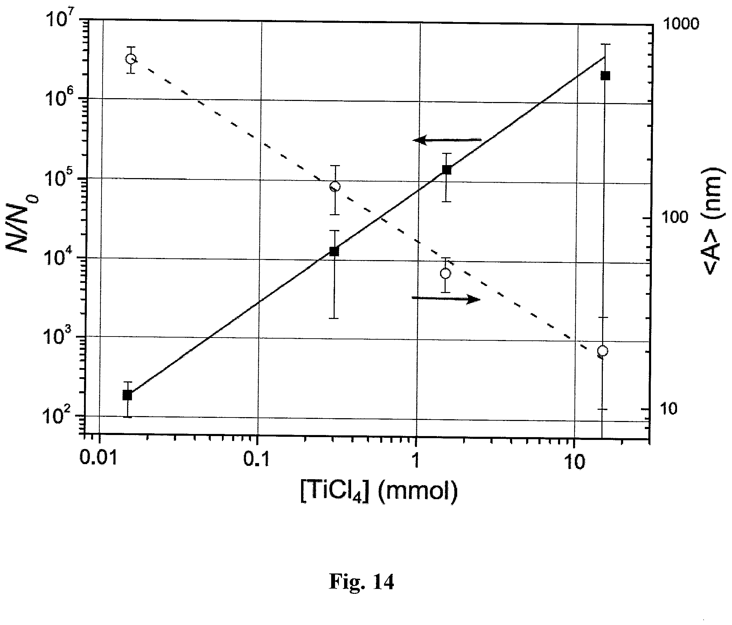

Figure 14 is a graph showing how the number of TiO₂ seeds (N) and hence the average crystal volume (inversely proportional to N) can be varied over 4 orders of magnitude by varying the seeding solution concentration ([TiCl₄(aq)]) from 15 M to 15 mM.

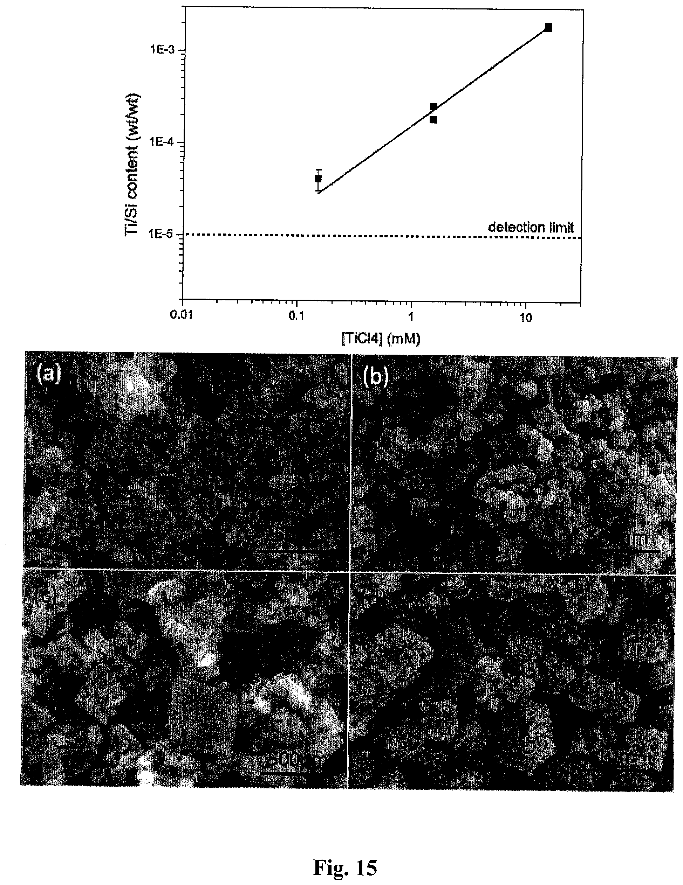

Figure 15 shows the seeding density dependence of mesoporous TiO₂ single crystals (MSCs), as determined by inductively coupled plasma optical emission spectroscopy (ICPOES) and SEM characterisation. The top panel shows the ratio of Ti to Si (wt/wt) in silica bead templates following seeding treatment at 70°C for 60 min at a range of TiCl₄ (aq) concentrations. The bottom panel (a-d) shows SEM images of seeded TiO₂ MSC morphologies over a range of (decreasing) crystal seeding conditions: 15; 1.5; 0.3; 0.015 mmol [TiCl4(aq)]. Final hydrothermal reaction conditions were 210°C, 12 h, 20mM TiF4 in all cases (note change in scale).

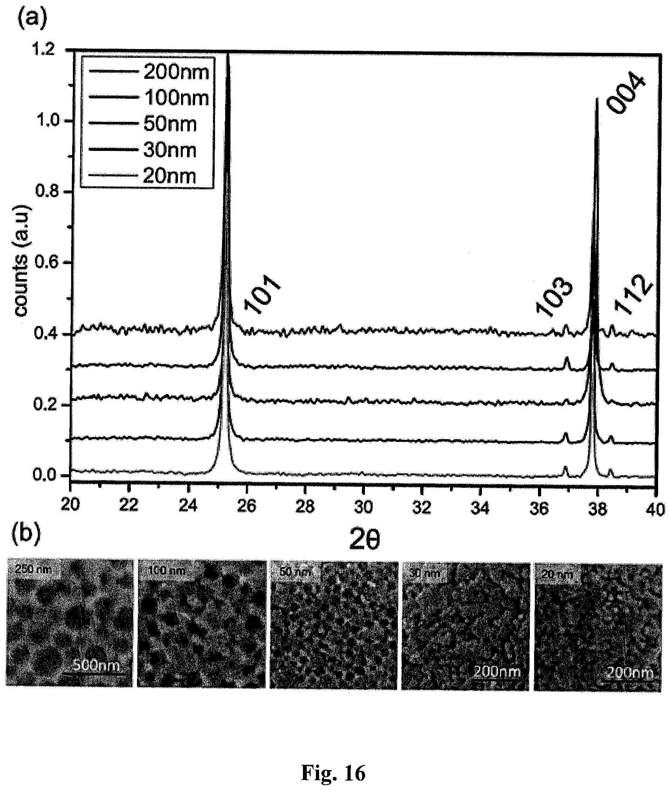

Figure 16 shows XRD Peak width dependence on MSC pore size: (a) XRD patterns of an ensemble of mesoporous TiO₂ crystals with average pore size ranging from 20 to 200nm; and (b) corresponding SEM images showing MSC pore morphologies (note change in scale).

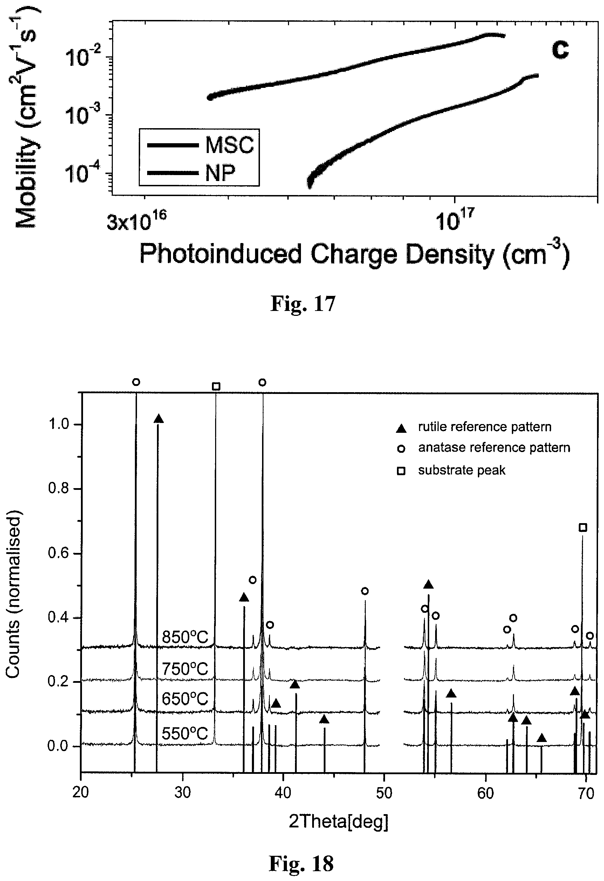

Figure 17 is a graph of mobility (y axis) in units of cm²V⁻¹s⁻¹, versus photoinduced charge density (x axis) in units of cm⁻³, which compares the mobiliy of a film of the mesoporous TiO₂ single crystals of the invention with a mesoporous film constructed from sintered nanoparticles. The MSC films exhibit mobility values over an order of magnitude higher than the sintered nanoparticle films over a broad range of charge densities.
Figure 18 shows XRD characterisation of TiO₂ MSCs thermally treated for 60mins within a silica template between 550 and 850°C alongside standard reference patterns for TiO₂ anatase and rutile phases. The observed phase is indexed to anatase in all cases.

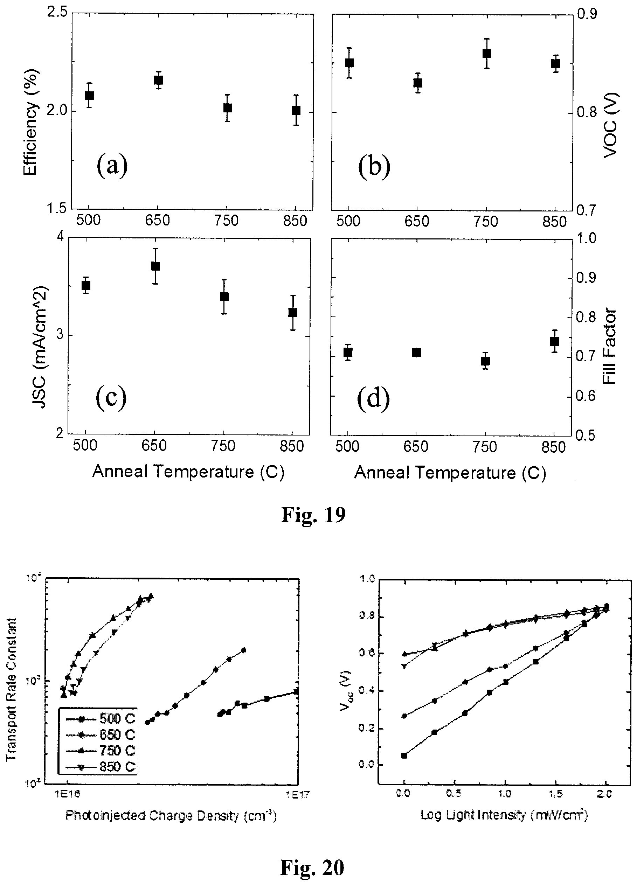

Figure 19 shows the Efficiency (a), Open Circuit Voltage (b), Short Circuit Current (c), and Fill Factor (d) for solid state dye sensitized solar cells fabricated with MSCs annealed at different temperatures.
Figure 20: (a) Transport Rate Constant dependence on charge density and (b) Open Circuit Voltage dependence on Light Intensity for solar cells fabricated with MSCs pre-annealed between 500 and 850°C.

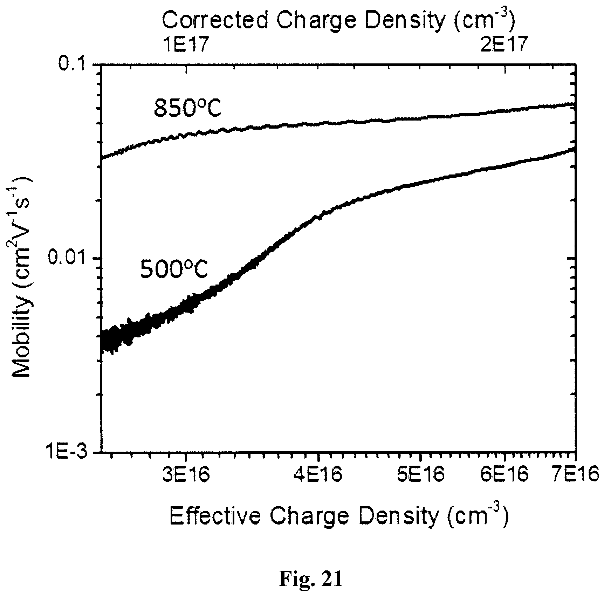

Figure 21: Mobility as a function of charge density for MSC films pre-annealed at 500°C or 850°C.

### DETAILED DESCRIPTION OF THE INVENTION

The invention provides a process for producing a mesoporous single crystal of a semiconductor, wherein the shortest external dimension of said single crystal, measured along any of the crystallographic principal axes of said crystal is x, wherein x is equal to or greater than 50 nm, which process comprises: providing a mesoporous template material, the mesoporous template material comprising a material comprising pores; producing a seeded mesoporous template material which comprises a seed crystal of the semiconductor disposed in a pore of the mesoporous template material, by growing said seed crystal in the mesoporous template material; and subsequently growing a single crystal of the semiconductor within the seeded mesoporous template material until said shortest external dimension of the single crystal is x, wherein x is equal to or greater than 50 nm.

The volume of said single crystal may be y, wherein y is equal to or greater than 1.25x10⁵ nm³. In this embodiment the process comprises growing said single crystal within the mesoporous template material until the volume of said single crystal is y, wherein y is equal to or greater than 1.25x10⁵ nm³.

The process is applicable to an enormous range of template morphologies and functional materials, both from solution and vapour phase reactions. The crystal is grown within the template material using any crystal growing method, including for instance from solution (i.e. by contacting a crystal growing solution with said mesoporous template material) or from vapour (i.e. by vapour phase crystallisation).

The term "mesoporous single crystal", as used herein, refers to a single crystal of a material, in this case a semiconductor, with a mesoporous structure. The semiconducting material forms a framework, within which pores are arranged. The pores within the mesoporous single crystal are the volumes within the crystal where there is no semiconducting material.

The term "single crystal", as used herein, refers to a crystal in which the crystal lattice is continuous and unbroken to the edges of the crystal. A single crystal is formed by the growth of a crystal nucleus without secondary nucleation. Ideally, a single crystal is without internal boundaries or defects in atomic packing.

The term "mesoporous", as used herein means that the pores in the porous structure are microscopic and have a size which is usefully measured in nanometres (nm). The mean pore size of the pores within a "mesoporous" structure may for instance be anywhere in the range of from 0.5 nm to 1,000 nm, or for instance from 1 nm to 1,000 nm. The mean pore size of the pores within a mesoporous structure may for example be from 1 nm to 500 nm, or for instance from 1 nm to 200 nm. Individual pores may be different sizes and may be any shape.

The term "pore size", as used herein, defines the size of the pores. For spherical pores, the pore size is equal to the diameter of the sphere. For pores that are not spherical, the pore size is equal to the diameter of a sphere, the volume of said sphere being equal to the volume of the non-spherical pore. This definition of pore size applies to the pores within said mesoporous single crystal and the pores within said porous template.

The term "semiconductor" as used herein refers to a material with electrical conductivity intermediate in magnitude between that of a conductor and an insulator. Typically, a semiconductor is a material that has a conductivity of from 10³ to 10⁻⁸ Scm⁻¹. Standard techniques such as a 4-point probe conductivity measurement may be used to measure conductivity. Examples of semiconductors include oxides of titanium, niobium, tin, zinc, cadmium, copper or lead; chalcogenides of antimony or bismuth; copper zinc tin sulphide; copper indium gallium selenide; and copper indium gallium diselenide. Further examples are group IV compound semiconductors (e.g. silicon carbide); group III-V semiconductors (e.g. gallium arsenide); group II-VI semiconductors (e.g. cadmium selenide); group I-VII semiconductors (e.g. cuprous chloride); group IV-VI semiconductors (e.g. lead selenide); group V-VI semiconductors (e.g. bismuth telluride); and group II-V semiconductors (e.g. cadmium arsenide); ternary or quaternary semiconductors (eg. Copper Indium Selenide, Copper indium gallium di-selenide, or copper zinc tin sulphide). Examples of materials which are not semiconductors include, for instance elemental metals, which are of course conductors, and electrical insulators or dielectrics such as silica or calcite.

The "shortest external dimension" of said single crystal, as used herein, means the shortest distance from one end of the crystal to the other as measured along any of the crystallographic principal axes. Generally, this means the shortest of the length, width or breadth of the crystal as measured along any of the crystallographic principal axes. For example, cubic, tetragonal and orthorhombic crystals have three crystallographic principal axes, denoted a, b and c respectively, which correspond to the three edges of the crystal that are perpendicular to each other. In these cases, the shortest external dimension of the crystal is the shortest of the length, width and breadth of the crystal as measured along the three principal axes a, b and c. (Of course, if the crystal is an ideal cube then the external dimensions measured along the three principal axes a, b and c will be the same, and any of these three distances can therefore be taken to be the "shortest external dimension" of the crystal.)

Individual mesoporous single crystals can be imaged using electron microscopy, for instance scanning electron microscopy (SEM). These images may then be used to obtain the shortest external crystal dimension. The average external dimension of the crystal can be measured by light scattering of a liquid dispersion of the crystals. X-ray scattering can also be used to determine the crystal domain size, and hence the shortest external dimension of the crystal, via peak broadening. Thus, the shortest external crystal dimension is readily measurable using techniques which are well known to the skilled person, including by electron microscopy and by other real space imaging techniques with sufficient resolution or by X-ray scattering.

The mesoporous template material is a material comprising pores. The template has an open structure in which pores are interconnected. This open structure enables the crystals to grow within the pores of the template material. The process of the invention comprises growing a single crystal of a semiconductor within a mesoporous template material until shortest external crystal dimension of said single crystal is x, wherein x is as defined herein. Growth of the single crystal need not however be confined to within the template materials. Thus the process may further comprise growing the single crystal out of the confines of the mesoporous template material.

Usually, the process of the invention is a process for producing said mesoporous single crystal, wherein the volume of said single crystal is y, wherein y is equal to or greater than 1.25x10⁵ nm³. In this case the process comprises growing said single crystal within the mesoporous template material until the volume of said single crystal is y.

The term "volume", in this context, refers to the geometric volume of the whole of the single crystal, including both the pores and the semiconductor. Individual mesoporous single crystals can be imaged using electron microscopy, for instance by scanning electron microscopy (SEM). These images may then be used to obtain the dimensions of the single crystal and the volume of the single crystal may be calculated.

Typically, the mesoporous template material used in the process of the invention comprises a mesoporous inorganic material, for instance silica or aluminosilicate. Alternatively, it may comprise a mesoporous carbon-based material. For instance, the mesoporous template material may be mesoporous black carbon, or a mesoporous polymer, for instance a block copolymer. The mesoporous polymer may be a mesoporous microphase-separate polymer or a block-copolymer with one component selectively removed. Alternatively, the mesoporous carbon-based material may be an assembly of polymer nanoparticles, for instance an assembly of polystyrene spheres.

Usually, the mesoporous template material comprises silica. Thus, the mesoporous template material is typically mesoporous silica. The mesoporous silica may for instance comprise sintered particles of silica. The sintered silica particles may have a mean particle size of from 10 nm to 400 nm, for instance from 10 nm to 90 nm. Usually, the sintered silica particles may have a mean particle size of from 40 nm to 60 nm. Typically, the sintered silica particles have a particle size of about 50 nm. The silica particles are typically sintered at a temperature of from 400 °C to 600 °C. The sintered silica particles are typically substantially spherical in shape. The sintered silica particles typically provide an approximately close-packed sphere template for growth of the mesoporous single crystal.

The term "particle size", as used herein, defines the size of particles. For spherical particles, the particle size is equal to the diameter of the sphere. For particles that are not spherical, the particle size is equal to the diameter of a sphere, the volume of said sphere being equal to the volume of the non-spherical particle in question.

In order to increase the relative yield of templated crystals, conditions may be imposed under which crystal nucleation occurs preferentially (or exclusively) within the template pores (as opposed to outside of the template material, for instance in a reaction vessel). To achieve this, one or more pre-formed nucleation sites may be disposed on the surface of the template pores, to act as nucleation points for subsequent crystal growth. This also allows for alteration of the reaction conditions such that the rate of homogeneous nucleation is significantly reduced or completely eliminated (i.e. by reducing temperature or precursor concentration).

Accordingly, in the process of the invention the seed crystal of the semiconductor is disposed in a pore of said mesoporous template material. It is typically present on the wall of a pore.

The volume of the seed crystal is typically less than or equal to 1000 nm³. More typically, the volume of the seed crystal is less than or equal to 500 nm³, for instance, less than or equal to 125 nm³. Even more typically, the volume of the seed crystal less than or equal to 125 nm³, for instance about 15 nm³.

Typically, the seeded mesoporous template material comprises a plurality of said seed crystals of said semiconductor. Typically, each seed crystal is disposed in a pore of said mesoporous template material. The pores in which the seed crystals are disposed may be the same or different. Preferably each seed crystal is disposed in a different pore.

Typically, the mesoporous template material has a porosity of less than or equal to 70 %. In one embodiment, the mesoporous template material has a porosity of from 10 % to 70 %, for instance the porosity of the mesoporous template material is from about 20 % to about 60 %. More typically, the porosity of the mesoporous template material is from 30 % to 50 %, for instance is about 40 %.

The mean pore size of the pores in the mesoporous template material used in the process of the present invention is typically from 0.5 nm to 1000 nm, for instance from 1 nm to 1000 nm. In one embodiment, the mean pore size of the pores in the mesoporous template material used in the process of the present invention is from 2 nm to 1000 nm. The mean pore size of the pores in the mesoporous template material may for instance be from 5 nm to 270 nm, or for instance from 10 nm to 260 nm. In a preferred embodiment, the mean pore size of the pores in the mesoporous template material is from 20 nm to 250 nm.

More typically, the mean pore size of the pores in the mesoporous template material is from 5 nm to 200 nm, for instance, the mean pore size of the pores in the mesoporous template material may be from 10 nm to 60 nm.

The semiconductor typically comprises an oxide or chalcogenide of a metal or metalloid element. Thus, the semiconductor may for instance comprise an oxide of titanium, niobium, tin, zinc, cadmium, copper or lead or any combination thereof; a chalcogenide of antimony, bismuth or cadmium or any combination thereof, or for instance zinc tin oxide; copper zinc tin sulphide; copper indium gallium selenide, or copper indium gallium diselenide. The semiconductor may for instance be a group IV compound semiconductor (e.g. silicon carbide); a group III-V semiconductor (e.g. gallium arsenide); a group II-VI semiconductor (e.g. cadmium selenide); a group I-VII semiconductor (e.g. cuprous chloride); a group IV-VI semiconductor (e.g. lead selenide); a group V-VI semiconductor (e.g. bismuth telluride); or a group II-V semiconductor (e.g. cadmium arsenide). The semiconductor may alternatively be a ternary or quaternary compound semiconductor, for instance zinc tin oxide; copper indium selenide; copper zinc tin sulphide; copper indium gallium selenide, or copper indium gallium diselenide. The semiconductor may alternatively be an elemental semiconductor, for instance Si or Ge. The semiconductor may alternatively be a nitride, for instance titanium nitride or boron nitride.

Thus, in one embodiment the semiconductor is selected from oxides and chalcogenides of metals and metalloid elements; group IV compounds; compounds comprising a group III element and a group V element; compounds comprising a group II element and a group VI element; compounds comprising a group I element and a group VII element; compounds comprising a group IV element and a group VI element; compounds comprising a group V element and a group VI element; compounds comprising a group II element and a group V element; ternary and quaternary compound semiconductors; and elemental semiconductors.

Usually, however, the semiconductor comprises an oxide or chalcogenide of a metal or metalloid element. Thus, typically, the semiconductor comprises an oxide of titanium, niobium, tin, zinc, cadmium, copper or lead or any combination thereof; a chalcogenide of antimony, bismuth or cadmium or any combination thereof; zinc tin oxide; copper zinc tin sulphide; copper indium gallium selenide, or copper indium gallium diselenide.

In some embodiments, the semiconductor comprises an oxide of a metal or metalloid element.

It is to be understood that the terms "metal oxide" and "an oxide of a metal element" used herein encompass both oxides comprising one metal, and also mixed-metal oxides. For the avoidance of doubt, a mixed-metal oxide refers to a single oxide compound comprising more than one metal element. Examples of mixed-metal oxides include zinc tin oxide and indium tin oxide. Similarly, it is to be understood that the terms "metalloid oxide" and "an oxide of a metalloid element" used herein encompass oxides comprising one metalloid element and also mixed-metalloid oxides. For the avoidance of doubt, a mixed-metalloid oxide refers to a single oxide compound comprising more than one metalloid element.

It is to be understood that the terms "metal chalcogenide" and "a chalcogenide of a metal element" encompass chalcogenides comprising one metal and also mixed-metal chalcogenides. For the avoidance of doubt, a mixed-metal chalcogenide refers to a single chalcogenide compound comprising more than one metal element. Similarly, it is to be understood that the terms "metalloid chalcogenide" and "a chalcogenide of a metalloid element" used herein encompass chalcogenides comprising one metalloid and also mixed-metalloid chalcogenides. For the avoidance of doubt, a mixed-metalloid chalcogenide refers to a single chalcogenide compound comprising more than one metalloid element.

Usually, said semiconductor comprises an oxide or chalcogenide of a metal or metalloid element. Typically, the semiconductor consists of an oxide or chalcogenide of a metal or metalloid element. More typically, the semiconductor comprises an oxide of titanium, niobium, tin, zinc, cadmium, copper or lead or any combination thereof; or a chalcogenide of antimony, bismuth or cadmium or any combination thereof. For instance the semiconductor may comprise zinc tin oxide; copper zinc tin sulphide; copper indium gallium selenide, or copper indium gallium diselenide. Usually, the semiconductor comprises an oxide of a metal or metalloid element, for instance, an oxide of titanium, niobium, tin, zinc, cadmium, copper or lead or any combination thereof. Typically, it comprises titanium dioxide. The titanium dioxide may be in the anatase crystalline form. The semiconductor may consist essentially of titanium dioxide. In one embodiment, the semiconductor consists of titanium dioxide. Titanium dioxide is also referred to herein as titania. In a preferred embodiment, the titanium dioxide is anatase.

In one embodiment the semiconductor may be a doped semiconductor, where an impurity element is present at a concentration ranging between 0.1 to 40%. If the impurity element acts as an electron donor, then the semiconductor will be doped to become n-type, if the impurity element acts as an electron acceptor, then the semiconductor will be doped to become p-type. Examples of impurity elements which will dope TiO₂ to become n-type are Niobium, Vanadium and Manganese. Examples of impurity elements which will dope TiO₂ to become p-type are Magnesium, Aluminium. It is noted that for metal oxides doped with impurity metalloid elements which substitute the primary metalloid element, if the valency of the dopant is larger than the valancy of the primary mettalid element then the metal oxide will be n-type doped, if the valency of the dopant metalloid element is lower than that of the primary metalloid element then the metal oxide will be p-type doped. Any of the above mentioned elements can be used to dope any of the above mentioned semiconductors to different levels of efficacy and effect.

The term "metalloid" as used herein refers to elements of the periodic table that have both metallic and non-metallic properties. Examples of metalloid elements include germanium, arsenic and antimony.

The term "chalcogenide" as used herein refers to a chemical compound comprising a chalcogen ion and a second ion, wherein said second ion is more electropositive than said chalcogen ion. Examples of chalcogen ions include sulphide and selenide ions. Examples of chalcogenides include antimony sulphide and antimony selenide.

In one embodiment, when said semiconductor comprises an oxide or chalcogenide of a metal or metalloid element, the step of growing a single crystal of a semiconductor within a mesoporous template material until the shortest external dimension of said single crystal is x, wherein x is equal to or greater than 50 nm, comprises contacting a crystal growing solution with said seeded mesoporous template material, wherein the crystal growing solution comprises a salt of said metal or metalloid element dissolved in a solvent. For instance said step of growing a single crystal of the semiconductor may comprise contacting a crystal growing solution with said seeded mesoporous template material, wherein the crystal growing solution comprises a plurality of salts of metal or metalloid elements dissolved in a solvent. A plurality of said salts may, for example, be required when the semiconductor comprises an oxide which is a mixed-metal oxide.

The contacting of a crystal growing solution with said seeded mesoporous template material is typically performed at least until the shortest external dimension of said single crystal is x. Alternatively, the contacting is performed at least until the volume of said single crystal is y, wherein y is greater than or equal to 1.25x10⁵ nm³.

Any suitable solvent may be employed for the crystal growing solution. Typically, however, the solvent comprises water. Usually, the solvent is water.

If the oxide or chalcogenide of said metal or metalloid element is soluble in the solvent, the salt of said metal or metalloid element which is employed in the crystal growing solution may be said oxide or chalcogenide of said metal or metalloid element. Alternatively, however, the salt may be a precursor to said oxide or chalcogenide of said metal or metalloid element. The salt which is a precursor to the oxide or chalcogenide is typically soluble in said solvent. Preferably, the salt which is a precursor to said oxide or chalcogenide is a salt which is decomposable in said solvent to produce said oxide or chalcogenide of said metal or metalloid element.

In one embodiment, when the process of the invention comprises contacting a crystal growing solution with said seeded mesoporous template material, wherein the crystal growing solution comprises a salt of said metal or metalloid element dissolved in a solvent, the semiconductor comprises an oxide of a metal or metalloid element, and said salt of said metal or metalloid element is a salt which is hydrolysable to produce said oxide. Typically, that metal or metalloid element is a halide, a sulphide, an oxysulphide or an alkoxide of said metal or metalloid element.

Typically, said semiconductor comprises titanium dioxide and the salt of said metal or metalloid element is a halide of titanium. When the semiconductor comprises titanium dioxide, the crystal growing solution typically comprises titanium chloride or titanium fluoride, more typically titanium fluoride.

In one embodiment, when said semiconductor comprises titanium dioxide and the salt of said metal or metalloid element is a halide of titanium, the concentration of the salt in said crystal growing solution is equal to or less than 150 mM. Typically, the concentration of the salt in said crystal growing solution is from 10 mM to 150 mM. More typically, concentration of the salt in said crystal growing solution is from 10 mM to 80 mM. This latter range is advantageous when the salt of said metal or metalloid element is titanium fluoride, as less degradation of the template material is observed when the concentration of the salt in said crystal growing solution is in that range. Degradation of the template material observed for different concentrations within this range is shown in figure 5.

Usually, the amount of the mesoporous template material contacted with said crystal growing solution is more than or equal to 100 mg. Typically the amount of said mesoporous template material is from 100 mg to 100 g, for instance from 200 mg to 10 g. More typically, the amount of said mesoporous template material is from 400 mg to 1 g.

The amount of the mesoporous template material contacted with said crystal growing solution is usually at least 2 mg template per ml of said solution, more typically at least 10 mg template per ml of solution. In some embodiments the amount of said mesoporous template material contacted with said crystal growing solution is at least 30 mg template per ml of solution.

Typically, the crystal growing solution further comprises an acid. The acid may be any suitable acid, typically a mineral acid, for instance hydrochloric acid.

The pH of the crystal growing solution is usually less than or equal to 6, typically less than or equal to 3, for instance about 2.

Said contacting step in the process of the invention may comprise contacting said crystal growing solution with said seeded mesoporous template material in the presence of an ionic liquid, wherein the crystal growing solution comprises said salt of said metal or metalloid element dissolved in said solvent. The ionic liquid can be used as a crystallographic controlling agent. Preferably, the ionic liquid comprises 1-methylimidazolium tetrafluoroborate. When said contacting occurs in the presence of an ionic liquid, typically, the percent by volume of ionic liquid based on the total volume of the crystal growing solution and the ionic liquid is less than or equal to 20 %, for instance the percentage volume of ionic liquid is from 0.5 to 10 %. More typically, the percentage volume of ionic liquid is from 1 to 5 %.

Usually, the process of the invention comprises contacting said crystal growing solution with said seeded mesoporous template material at a crystal growing temperature. Typically, the crystal growing temperature is ambient temperature or an elevated temperature. Said crystal growing temperature may for instance be less than or equal to 300°C. More typically, it is less than or equal to 200°C. Said crystal growing temperature may for instance be from 20 °C to 300°C, for instance from 70°C to 300°C. Typically, said crystal growing temperature is from 100°C to 250°C. For instance, the crystal growing temperature may be from 100°C to 220°C.

Typically, in the process of the invention, the crystal growing solution is contacted with said seeded mesoporous template material at said crystal growing temperature for at least 30 minutes, more typically for at least 2 hours.

Usually, the step of contacting the crystal growing solution with said seeded mesoporous template material at said crystal growing temperature is performed in an autoclave. The crystal growing solution and the seeded mesoporous template material can be heated to said crystal growing temperature conventionally, or for instance by using microwave radiation.

When the process of the invention comprises contacting a crystal growing solution with said seeded mesoporous template material at a crystal growing temperature, the process may further comprise cooling the crystal growing solution and the seeded mesoporous template material. Typically, the crystal growing solution and the seeded mesoporous template material are cooled to a temperature of from 0 °C to 40 °C, more typically to around room temperature, for instance to a temperature of from 15 °C to 25 °C.

In one embodiment, when the process of the present invention comprises contacting said crystal growing solution with said seeded mesoporous template material, the process further comprises recovering the mesoporous template material from the crystal growing solution. Typically, said recovering comprises a solid-liquid separation step, for instance filtration or centrifugation. Optionally, said recovering further comprises washing said mesoporous template material. The mesoporous template material is usually washed with water.

The mesoporous template material used in the process of the invention is typically in the form of a solid powder or monolith.

In one embodiment, application of the seeded-template method under conditions of higher concentration of precursor species is desirable for two reasons: firstly, the mass of MSC product is thereby increased for a fixed reaction volume and secondly, the increased nucleation rate at a given temperature is a route to decrease MSC size. The ability to tune MSC size is important in applications that require deposition of thin film ensemble of MSCs on a substrate. The uniformity of the film is sensitive to the size of the composite MSCs relative to the desired film thickness. Smoother films are more easily obtained when the MSC size is smaller (typically at least 3 times) than the film thickness. The seeded-template method allows for MSC size to be controlled via seeding density as well as precursor concentration, however, the ability to tune both these parameters independently is advantageous for ease of processing (for example to reach the lowest possible reaction temperature) as well as to optimise the reaction yield of MSCs. A significant problem in using higher precursor concentration conditions is the simultaneous occurrence of homogeneous nucleation of crystals outside the template that leads to both non-porous and porous products that must be separated. Exactly when this regime is reached is dependent on a number of parameters (seed density, template mass, pH and additive concentration). In the case of the TiF₄ precursor salt this homogeneous nucleation is significant at concentrations of around 100mM at 130°C or above (for 1 gram of template material containing in 50ml reaction volume, pH 2, 180mM 1-butyl-3-methylimidazolium tetrafluoroborate additive). This problem can be avoided by ensuring that the external size of the mesoporous template material (in the form of a course-ground powder) is much larger than the target size of the nucleated crystal product. In this way upon reaction completion the filled template material can be separated from the liquid suspension of unwanted, non-porous crystals by simple filtration (where the filter allows passage of non-porous crystals, but not the grains of filled template), or separated via sedimentation (where the grains of filled template quickly settle to the base of the reaction vessel on standing or centrifugation). For example, template grains in the hundreds of micrometre to millimetre regime are relatively easily separable from bulk product crystals in the micrometre size regime. The size of the template grains can be dictated by sieving the powder through a known mesh size sieve before introduction to the reaction vessel.

Thus, in some embodiments, when said semiconductor comprises titanium dioxide and the salt of said metal or metalloid element is a halide of titanium (for instance TiF₄), the concentration of the salt in said crystal growing solution is equal to or greater than 100 mM. Typically, in such embodiments, the process further comprises a step of separating the template material and the mesoporous single crystal or crystals thus produced from non-porous crystals. Usually, the separation is performed by filtration or by sedimentation. Typically, in these embodiments, the template material comprises particles of the template material having a particle size of at least 100 µm, for instance a particle size of from 100 µm to 10 mm, or for instance from 100 µm to 1 mm.

The process of the invention may be performed *in situ* on a substrate suitable for use in a semiconducting device. Thus, a, or a plurality of, said single crystals can be produced within a layer of said template material which is disposed on a substrate. The template material may be removed after production of the single crystal or single crystals, to leave a layer comprising said single crystal or crystals disposed on the substrate. Accordingly, in one embodiment the mesoporous template material used in the process of the invention is in the form of a layer disposed on a substrate, which substrate is suitable for use in a semiconducting device. Preferably, the substrate comprises a material which is suitable for use as an electrode in a semiconducting device. The substrate typically further comprises a dense layer of the same semiconductor, for instance titania, disposed between the template layer and the material which is suitable for use as an electrode.

In one embodiment, a substrate is pre-treated with a coating of seed crystals and the template material is disposed on the pre-treated substrate. Said step of growing said single crystal of a semiconductor can then be performed within said template material, which is disposed on the pre-treated substrate. In this way, an array of adjoining single crystals can be nucleated and grown in parallel from the substrate into the porous template layer. Preferably, the substrate comprises a material which is suitable for use as an electrode in a semiconducting device. The template material may be as further define herein. For instance, the mesoporous template might be inorganic (such as silica) or organic such as mesoporous carbon.

Typically said semiconducting device is a photovoltaic device, a photodiode, a solar cell, a photo detector, a light-sensitive transistor, a phototransistor, a solid-state triode, a battery electrode, a light-emitting device or a light-emitting diode. For instance, said semiconducting device may be a dye-sensitised solar cell. The semiconducting device may be as further defined hereinbelow.

It has been found that an additional thermal sintering step, involving heating the mesoporous single crystals (MSCs) whilst still in the template material, can be employed in the process of the invention in order to improve electronic charge transport. The results in Example 5 herein and the accompanying Figures demonstrate that transport rate through an MSC film ensemble increases with increasing temperature, and that devices with MSCs annealed at higher temperatures lose less voltage under low illumination, suggesting that the dark electron density is higher in such devices. As shown in Figure 21, an MSC film annealed at 850°C exhibited an effective mobility which was about an order of magnitude higher at low charge densities than that annealed at 500°C. The results support that the increased background charge density in MSCs annealed at higher temperatures increases the electronic transport rate. Also, when anatase titania MSCs were annealed within the template, it was found that the anatase titania phase remained stable at temperatures well above the usually-observed anatase-rutile transition temperature of 500°C.

Accordingly, the process of the invention may further comprise a step of heating the single crystal thus produced, at an elevated temperature. The heating step is usually carried out whilst the single crystal is in the template material. Of course, since the process of the invention usually results in the production of a plurality of the single crystals within the template, this additional heating step usually comprises heating the single crystals thus produced, at the elevated temperature, whilst in the template material. Typically, the single crystal or crystals are heated at said temperature in air. However, for different influences on the MSCs, they may alternatively be heated in, for instance, an inert gas, such as nitrogen or argon, or in oxygen, or for instance in a gas which comprises hydrogen. For instance, the single crystal or crystals may be heated at said temperature in forming gas, which comprises nitrogen and hydrogen (the typical composition of forming gas is 92% nitrogen, 8% hydrogen). The heating may be referred to as annealing, or thermal sintering. Thus, the process of the invention may further comprise a step of annealing the single crystal or crystals thus produced, at an elevated temperature, whilst in the template material. Alternatively, the process of the invention may further comprise a step of sintering the single crystal or crystals thus produced, at an elevated temperature, whilst in the template material.

The temperature to which the single crystal or crystals are heated, i.e. the "elevated temperature", may be any temperature above ambient temperature which is suitable for increasing electronic charge transport in the semiconductor material. More particularly, it may be any temperature which is suitable for increasing electronic charge transport in a film comprising an ensemble of mesoporous single crystals of the semiconductor material. The suitable temperature will of course vary for different semiconductors. Usually, however, the elevated temperature is at least 400°C, and more typically it is at least 500°C. In preferred embodiments, the elevated temperature is greater than 500°C, for instance at least 600°C. More preferably, it is at least 700°C. In particularly preferred embodiments, the elevated temperature is at least 750°C. For instance, the elevated temperature may be at least 800°C, or for example at least 850°C. A temperature of 850°C, for instance, has been found to be particularly effective when the semiconductor comprises titania, as shown in Example 5 herein.

The elevated temperature is generally not more than 1200°C, for instance it is usually not more than 1100°C. Preferably the elevated temperature is not more than 1000°C.

Thus, the elevated temperature is typically from 400°C to 1200°C. The elevated temperature may for instance be from 500°C to 1100°C, or for instance from 600°C to 1000°C. In preferred embodiments, the elevated temperature is from 700°C to 1000°C, or for instance from 750°C to 1000°C. In particularly preferred embodiments, the elevated temperature is from 800°C to 1100°C, or for instance from 850°C to 1000°C.

Typically, the process of the invention further comprises recovering the mesoporous single crystal thus produced. The step of recovering the mesoporous single crystal typically comprises removing the mesoporous template material from around and within the mesoporous single crystal. Typically, said removing comprises etching, dissolving, decomposing, degrading or melting the mesoporous template material.

Said recovering may for instance comprise etching the template material by heating it in the presence of an alkaline solution. This method is particularly useful when the template material comprises mesoporous silica. Any suitable alkaline solution may be used. An aqueous solution of sodium hydroxide may for instance be employed. The concentration of sodium hydroxide is typically greater than 0.5 M. For instance it may be from 1 M to 5 M.

Said recovering typically further comprises a solid-liquid separation step, for instance filtration or centrifugation.

Said recovering usually further comprises washing the mesoporous single crystal thus produced. The single crystal may for instance be washed first with water and then with a protic organic solvent, for instance with ethanol.

The process of the invention usually results in the production of a plurality of said mesoporous single crystals of said semiconductor, within the template material. The template material may for instance comprise a plurality of crystal nucleation points, or it may be a seeded template material comprising a plurality of seed crystals, in which case the process generally results in the production of a plurality of said mesoporous single crystals.

Accordingly, the process of the invention for producing a mesoporous single crystal of a semiconductor may be a process for producing a plurality of said mesoporous single crystals. Each of the single crystals in the plurality may be as further defined herein.

In one embodiment, the process of the invention is a process for producing a mesoporous single crystal of a semiconductor, wherein the shortest external dimension of said single crystal is x, wherein x is equal to or greater than 100 nm. Optionally, x is equal to or greater than 500 nm. Typically, x is from 50 nm to 100 µm. More typically, x is from 500 nm to 10 µm.

In one embodiment, the volume of mesoporous single crystal produced by the process of the invention is y, wherein y is equal to or greater than 1,000,000 nm³. Typically, y is equal to or greater than 1.25x10⁸ nm³. For instance, y may be from 1.25x10⁵ nm³ to 1,000,000 µm³. Usually, y is from 1.25x10⁸ nm³ to 1,000 µm³.

In one embodiment, the process of the invention further comprises disposing an outer layer on a surface of the mesoporous single crystal or crystals thus produced, which outer layer comprises a semiconducting or dielectric material.

The process comprises producing said seeded mesoporous template material by growing the seed crystal of said semiconductor in the mesoporous template material. The process may for instance comprise producing said seeded mesoporous template material by growing a plurality of seed crystals of said semiconductor in the mesoporous template material. The mesoporous template material may be as further defined hereinbefore. Thus, typically, the mesoporous template comprises a mesoporous inorganic material or a mesoporous organic polymer. The mesoporous template may for instance comprise mesoporous silica. The porosity of said mesoporous template material is usually less than or equal to 70 %. In one embodiment, the mesoporous template material has a porosity of from 10 % to 70 %, for instance the porosity of the mesoporous template material may be from about 20 % to about 60 %. More typically, the porosity of the mesoporous template material is from 30 % to 50 %, for instance is about 40 %. The mesoporous template material may be as further defined herein.

Preferably, the semiconductor comprises an oxide or chalcogenide of a metal or metalloid element and the growing of said seed crystal comprises contacting a seed crystal growing solution with said mesoporous template material, wherein the seed crystal growing solution comprises a salt of said metal or metalloid element dissolved in a solvent. The salt of said metal or metalloid element may be as further defined hereinbefore.

Thus, usually, the semiconductor comprises an oxide or chalcogenide of a metal or metalloid element. Typically, the semiconductor consists of an oxide or chalcogenide of a metal or metalloid element. More typically, the semiconductor comprises an oxide of titanium, niobium, tin, zinc, cadmium, copper or lead or any combination thereof; or a chalcogenide of antimony, bismuth or cadmium or any combination thereof. For instance the semiconductor may comprise zinc tin oxide; copper zinc tin sulphide; copper indium gallium selenide, or copper indium gallium diselenide. Usually, the semiconductor comprises an oxide of a metal or metalloid element, for instance, an oxide of titanium, niobium, tin, zinc, cadmium, copper or lead or any combination thereof. Typically, it comprises titanium dioxide. The semiconductor may consist essentially of titanium dioxide. In one embodiment, the semiconductor consists of titanium dioxide. The titanium dioxide may for instance be anatase.

Any suitable solvent may be employed for the seed crystal growing solution. Typically, however, the solvent comprises water. Usually, the solvent is water. Alternatively, the solvent may be trioctylphosphine oxide. Trioctylphosphine oxide is especially suitable as the solvent when the semiconductor comprises a chalcogenide of a metal or metalloid element.

When the semiconductor comprises an oxide or chalcogenide of a metal or metalloid element, the salt of said metal or metalloid element may be said oxide or chalcogenide of said metal or metalloid element. Alternatively, it may be a salt which is a precursor to said oxide or chalcogenide of said metal or metalloid element. Typically, the salt which is a precursor to said oxide or chalcogenide is a salt which is decomposable in said solvent to produce said oxide or chalcogenide or said metal or metalloid element.

The semiconductor may for instance comprise an oxide of a metal or metalloid element, and said salt of said metal or metalloid element may be a salt which is hydrolysable to produce said oxide. For instance, said salt of said metal or metalloid element may be a halide, a sulphide, an oxysulphide or an alkoxide of said metal or metalloid element. The semiconductor may for instance comprise titanium dioxide, and the salt of said metal or metalloid element may be a halide of titanium, for instance titanium chloride.

The concentration of the salt in the seed crystal growing solution may for instance be equal to or less than 20 mM. In some embodiments, the concentration of the salt in said seed crystal growing solution is equal to or less than 10 mM. Typically, the concentration of the salt in said seed crystal growing solution is from 5 µM to 20 mM. For instance, the concentration of the salt in said seed crystal growing solution is from 5 µM to 10 mM. These concentration ranges are especially useful when the semiconductor comprises titanium dioxide and the salt of said metal or metalloid element is a halide of titanium.

Usually, the amount of the mesoporous template material contacted with said seed crystal growing solution is more than or equal to 100 mg. Typically the amount of said mesoporous template material is from 100 mg to 100 g. More typically, the amount of said mesoporous template material is from 500 mg to 10 g.

The seed crystal growing solution may further comprise an acid. The acid may be any suitable acid. Typically the acid is a mineral acid, for instance hydrochloric acid. Typically, the pH of the seed crystal growing solution is less than or equal to 6, for instance less than or equal to 3, for instance about 2. These pH's have been found to be especially useful when the semiconductor comprises titanium dioxide and the salt of said metal or metalloid element is a halide of titanium.

In one embodiment, when the process of the present invention comprises contacting a seed crystal growing solution with said mesoporous template material, said contacting comprises contacting said seed crystal growing solution with said mesoporous template material at an seed crystal growing temperature. Typically, the seed crystal growing temperature is from 30°C to 150°C. More typically, the seed crystal growing temperature is from 60°C to 100°C. Typically the contacting of said seed crystal growing solution with said mesoporous template material at said seed crystal growing temperature occurs for up to 3 hours. More typically, the contacting of said seed crystal growing solution with said mesoporous template material at said seed crystal growing temperature occurs for from 30 minutes to 2 hours.

When the process of the present invention comprises contacting a seed crystal growing solution with said mesoporous template material, in one embodiment, the process further comprises recovering the seeded mesoporous template material from the seed crystal growing solution. Said recovering usually comprises a solid-liquid separation step, for instance filtration or centrifugation. Optionally, said recovering further comprises washing said seeded mesoporous template material. The seeded mesoporous template material is usually washed with water.

In one embodiment, when the process of the invention comprises producing said seeded mesoporous template material by growing the seed crystal of said semiconductor in the mesoporous template material, the process further comprises re-sintering the seeded mesoporous template material thus produced, by heating the seeded mesoporous template material to a temperature suitable for sintering. Typically, the temperature suitable for sintering is at least 400°C, for instance it may be from 400°C to 600°C.

The mesoporous single crystal or crystals produced by the process of the invention typically has a porosity of equal to or greater than 30 %. The porosity may for instance be equal to or greater than 50 %. In some embodiments, the porosity of the mesoporous single crystal is from 50 % to 90 %, or for instance from 50 % to 70 %.

The mean pore size of the pores within the mesoporous single crystal produced by the process of the invention is usually equal to or greater than 5 nm. The mean pore size of the pores within the mesoporous single crystal may for instance be from 5 nm to 270 nm, or for instance from 10 nm to 260 nm. In a preferred embodiment, the mean pore size of the pores within the mesoporous single crystal is from 20 nm to 250 nm.

Typically, the mean pore size of the pores within said mesoporous single crystal is from 5 nm to 200 nm. The mean pore size of the pores within said mesoporous single crystal may for instance be from 5 nm to 50 nm.

The process of the present invention may be used to produce a mesoporous single crystal having an aspect ratio of greater than or equal 1.3. Mesoporous single crystals having an aspect ratio greater than or equal 1.5 may for instance be produced. Usually, the aspect ratio is greater than or equal to 2. In one embodiment, the aspect ratio is greater than or equal to 10. The aspect ratio of the crystal produced by the process of the invention may for instance be greater than or equal to 20, or , for instance, greater than or equal to 50.

The term "aspect ratio", as used herein, refers to the ratio of the shortest of the length, width and breadth of said mesoporous single crystal, to the longest of the of the length, width and breadth of said mesoporous single crystal.

The mesoporous single crystal or crystals produced by the process of the invention typically have a surface area, which is a combination of both the external crystal and internal surface of the pore walls, of equal to or greater than 25 m²/g. For instance, mesoporous single crystals having a surface area equal to or greater than 50 m²/g, or for instance equal to or greater than 100 m²/g, may be produced. The surface area of the mesoporous single crystal provided by the process of the invention may for instance be from 25 m²/g to 150 m²/g, or for instance from 50 m²/g to 100 m²/g.

The process of the present invention may be used to produce a mesoporous single crystal of any crystalline semiconductor. The process may for instance be used to produce a mesoporous single crystal of a semiconductor which comprises an oxide or chalcogenide of a metal or metalloid element. The semiconductor may for instance consist essentially of an oxide or chalcogenide of a metal or metalloid element. In one embodiment, the semiconductor consists of an oxide or chalcogenide of a metal or metalloid element.

The semiconductor may for instance comprise an oxide of titanium, niobium, tin, zinc, cadmium, copper or lead or any combination thereof; a chalcogenide (for instance a sulphide or a selenide) of antimony, bismuth or cadmium or any combination thereof. In one embodiment the semiconductor consists essentially of an oxide of titanium, niobium, tin, zinc, cadmium, copper or lead or any combination thereof; a chalcogenide (for instance a sulphide or a selenide) of antimony, bismuth or cadmium or any combination thereof. The semiconductor may for instance consist of an oxide of titanium, niobium, tin, zinc, cadmium, copper or lead or any combination thereof; a chalcogenide (for instance a sulphide or a selenide) of antimony, bismuth or cadmium or any combination thereof.

Typically, the semiconductor comprises an oxide of a metal or metalloid element, for instance, titanium dioxide.

When the semiconductor comprises an oxide of a metal or metalloid element typically the semiconductor consists essentially of said oxide of a metal or metalloid element. The semiconductor may for instance consist of said oxide of a metal or metalloid element.

Typically, the semiconductor consists essentially of titanium dioxide. More typically, the semiconductor consists of titanium dioxide. The titanium dioxide may for instance be anatase.

The invention further provides a mesoporous single crystal of a semiconductor, wherein the shortest external dimension of said single crystal measured along any of the crystallographic principal axes of said single crystal is equal to or greater than 50 nm.

Typically, said shortest external dimension of said single crystal is equal to or greater than 100 nm. More typically, said shortest external dimension of said single crystal is equal to or greater than 500 nm. Said shortest external dimension of said single crystal may for instance be from 50 nm to 100 µm. The shortest external dimension of said single crystal is usually from 200 nm to 10 µm. Said shortest external dimension of said single crystal may for instance be from 300 nm to 10 µm, or for instance from 500 nm to 10 µm.

The volume of the mesoporous single crystal of the invention is typically equal to or greater than 1.25x10⁵ nm³. For instance, the volume of said single crystal may be equal to or greater than 1,000,000 nm³. More typically, the volume of said single crystal is equal to or greater than 1.25x10⁸ nm³. The volume of said single crystal may for instance be from 1.25x10⁵ nm³ to 1,000,000 µm³. In some embodiments, it is from 1.25x10⁸ nm³ to 1,000 µm³.

The porosity of the mesoporous single crystal of the invention is typically equal to or greater than 30 %. The porosity of the single crystal may for instance be equal to or greater than 50 %. Usually, the porosity of the mesoporous single crystal is from 50 % to 70 %.

In one embodiment, the mean pore size of the pores within the mesoporous single crystal of the invention is equal to or greater than 5 nm. The mean pore size of the pores within the mesoporous single crystal of the invention may for instance be from 5 nm to 270 nm, or for instance from 10 nm to 260 nm. In a preferred embodiment, the mean pore size of the pores within the mesoporous single crystal is from 20 nm to 250 nm.

The mean pore size of the pores within said mesoporous single crystal may for instance be from 5 nm to 200 nm. Typically, the mean pore size of the pores within said mesoporous single crystal is from 5 nm to 50 nm.

In some embodiments, the aspect ratio of the mesoporous single crystal of the invention is greater than or equal 1.3. The aspect ratio may for instance be greater than or equal 1.5. In some embodiments, the aspect ratio is greater than or equal to 2. The aspect ratio may for example be greater than or equal to 10, for instance is greater than or equal to 20. The aspect ratio is in some embodiments greater than or equal to 50.

Typically, the surface area of the mesoporous single crystal of the invention is equal to or greater than 25 m²/g. The surface area of the mesoporous single crystal may for instance be from 25 m²/g to 250 m²/g. In some embodiments, the surface area of the mesoporous single crystal is from 50 m²/g to 150 m²/g, or for instance from 50 m²/g to 100 m²/g.

The mesoporous single crystal of the invention is typically a mesoporous single crystal of a semiconductor which comprises an oxide or chalcogenide of a metal or metalloid element. Thus, the semiconductor may for instance comprise an oxide of titanium, niobium, tin, zinc, cadmium, copper or lead or any combination thereof; a chalcogenide of antimony, bismuth or cadmium or any combination thereof, or for instance zinc tin oxide; copper zinc tin sulphide; copper indium gallium selenide, or copper indium gallium diselenide. The semiconductor may for instance be a group IV compound semiconductor (e.g. silicon carbide); a group III-V semiconductor (e.g. gallium arsenide); a group II-VI semiconductor (e.g. cadmium selenide); a group I-VII semiconductor (e.g. cuprous chloride); a group IV-VI semiconductor (e.g. lead selenide); a group V-VI semiconductor (e.g. bismuth telluride); or a group II-V semiconductor (e.g. cadmium arsenide). The semiconductor may alternatively be a ternary or quaternary compound semiconductor, for instance zinc tin oxide; copper zinc tin sulphide; copper indium gallium selenide, or copper indium gallium diselenide.

Thus, in one embodiment the mesoporous single crystal of the invention is a mesoporous single crystal of a semiconductor selected from oxides and chalcogenides of metals and metalloid elements; group IV compounds; compounds comprising a group III element and a group V element; compounds comprising a group II element and a group VI element; compounds comprising a group I element and a group VII element; compounds comprising a group IV element and a group VI element; compounds comprising a group V element and a group VI element; compounds comprising a group II element and a group V element; and ternary and quaternary compound semiconductors.

Usually, however, the mesoporous single crystal of the invention is a mesoporous single crystal of oxide or chalcogenide of a metal or metalloid element. Thus, typically, the mesoporous single crystal of the invention is a mesoporous single crystal of an oxide of titanium, niobium, tin, zinc, cadmium, copper or lead or any combination thereof; a chalcogenide of antimony, bismuth or cadmium or any combination thereof; zinc tin oxide; copper zinc tin sulphide; copper indium gallium selenide, or copper indium gallium diselenide.

The mesoporous single crystal of the invention is typically a mesoporous single crystal of a semiconductor which comprises an oxide or chalcogenide of a metal or metalloid element. The semiconductor may for instance consist essentially of an oxide or chalcogenide of a metal or metalloid element. In one embodiment, the semiconductor consists of an oxide or chalcogenide of a metal or metalloid element.

The semiconductor may for instance comprise an oxide of titanium, niobium, tin, zinc, cadmium, copper or lead or any combination thereof; a chalcogenide (for instance a sulphide or a selenide) of antimony, bismuth or cadmium or any combination thereof. In one embodiment the semiconductor consists essentially of an oxide of titanium, niobium, tin, zinc, cadmium, copper or lead or any combination thereof; a chalcogenide (for instance a sulphide or a selenide) of antimony, bismuth or cadmium or any combination thereof. The semiconductor may for instance consist of an oxide of titanium, niobium, tin, zinc, cadmium, copper or lead or any combination thereof; a chalcogenide (for instance a sulphide or a selenide) of antimony, bismuth or cadmium or any combination thereof.

Typically, the semiconductor comprises an oxide of a metal or metalloid element, for instance, titanium dioxide. The titanium dioxide may for instance be anatase.

When the semiconductor comprises an oxide of a metal or metalloid element typically the semiconductor consists essentially of said oxide of a metal or metalloid element. The semiconductor may for instance consist of said oxide of a metal or metalloid element.

Typically, the semiconductor consists essentially of titanium dioxide. More typically, the semiconductor consists of titanium dioxide. Typically, the titanium dioxide is anatase.

In one embodiment, the mesoporous single crystal of the invention further comprises an outer layer disposed on a surface of the crystal, which outer layer comprises a semiconducting or dielectric material.

The invention also provides a composition which comprises a plurality of mesoporous single crystals of the invention as defined herein.

The invention also provides a semiconducting layer which comprises a plurality of mesoporous single crystals of the invention as defined herein.

The invention also provides a semiconducting device which comprises at least one layer that comprises a mesoporous single crystal of the invention as defined herein. Typically, said layer comprises a plurality of mesoporous single crystals of the invention. The semiconducting device may be a photovoltaic device, a photodiode, a solar cell, a photo detector, a light-sensitive transistor, a phototransistor, a solid-state triode, a battery electrode, a light-emitting device or a light-emitting diode.

In one embodiment, the semiconducting device is a photovoltaic device and the layer that comprises said mesoporous single crystal of the invention is a photoactive layer. Typically said mesoporous single crystal will comprise a surface dye coating. Optionally, the device further comprises an electrolyte or hole transport medium.

In one embodiment, the semiconducting device is a solar cell.

In one embodiment, the semiconducting device is a hybrid solar cell, which comprises said mesoporous single crystal and an organic charge conducting semiconductor.

In one embodiment, the semiconducting device is a dye-sensitised solar cell (DSC).

Charge transport in semiconducting devices is typically limited by electron trapping and scattering in the semiconductor material. The mesoporous single crystals of the present invention have a high surface area and a low number of grain boundaries, compared to materials in the prior art. Semiconducting devices which comprise at least one layer that comprises a mesoporous single crystal are thus expected to show surprisingly high charge mobility and high device efficiency.

In one embodiment, said mesoporous single crystal of the invention in said semiconducting device is an actively absorbing scattering component that increases the light path in said photovoltaic layer.

In one embodiment, the semiconducting device is an organic:inorganic bulk heterojunction device. Typically, said device comprises said mesoporous single crystal and a p-type polymer semiconductor.

The invention is further described in the following Examples.

### EXAMPLES

### Example 1

Yang et al. showed that anatase TiO₂ crystals with domain size in the micrometer range could be achieved by hydrothermal synthesis from a fluoride precursor (TiF₄) at a certain pH, temperature and in the presence of additives that act to partially stabilise TiF₄ to hydrolysis. For example, bulk (non-porous) single crystals of anatase TiO₂ were synthesized in a 125 ml PTFE-lined autoclave from 50 ml of an aqueous TiF₄ precursor in the presence of an ionic liquid crystallographic controlling agent (1-methylimidazolium tetrafluoroborate) at 210 °C for 12 h at an initial TiF₄ concentration of 20mM and ionic liquid concentration of 177 mM. SEM and XRD analysis of the reaction product (Figure 1b) revealed truncated bipyramidal anatase TiO₂ crystals approximately 3.3 µm in the a-b plane, and 1 µm in the c direction.

This Example demonstrates that it is possible to nucleate and grow microcrystals within the mesoscale pores of a host template. The template employed here is formed from a quasi close-packed array of silica beads approximately 50 nm in diameter synthesised according to Bogush et al. (Journal of Non-Crystalline Solids 104(1), 95 (1998)), and used here in the form of a course-ground (∼1 µm to 1 mm grain size) bulk powder. 650 mg of the template material was added to 50 ml of the reaction solution described above. After 12 h the (in-tact) silica was recovered from the base of the autoclave and subjected to an etching reaction for silica (2M NaOH(aq)) to remove the template phase. SEM inspection of the final product (cleaned by centrifugation and washing) revealed that the overwhelming majority of the TiO₂ was in the form of bulk (non-porous) microcrystals, indicating nucleation and growth in the bulk of the solution, or walls of the reaction vessel. However, a trace quantity of crystals were identified in which an mesoporous structure is clearly visible, indicating replication of the silica template pores by the growing crystal. The external size and shape of the porous microcrystals is otherwise identical to the non-templated, faceted crystals. The ratio of porous to non-porous crystals is proporational to the number fraction of crystals that nucleate in the template pores. Assuming no preferential heterogenous nucleation on the silica surface, this is equal to the ratio of the total template pore volume (∼ 0:33cm3g⁻¹) to the reaction volume (50 ml). Under these conditions it is therefore expected only 0.6% of the total number of crystals to nucleate inside the template pores.

Figure 1 shows a comparison of mesoporous semiconductor crystals with previous state-of-the-art mesoporous TiO₂. (a) a mesoporous ceramic sponge made by thermal sintering of 25nm anatase nanoparticles at 500°C. (b) oriented attachement of 10nm TiO2 nanocrystallites within the pores of a guiding silica template, (c) synthesis of TiO₂ single domain microcystals. with typical truncated bipyramidal anatase TiO₂ faceted form produced by hydrolysis of 20mM TiF₄ at 210 °C. Inset is the electron diffraction pattern from a single crystal which can be indexed to the [001] zone axis of anatase TiO₂. (d) Anatase XRD pattern of the sample in (c). (e) Mesoporous TiO₂ microcrystal (after template removal) synthesized under identical conditions to (c) however now replicating the pore structure of a 50nm silica bead template, (d) magnified image of the mesoscale porous morphology of the crystal in (c) with the electron diffraction of the complete crystal inset.

Two possible strategies could be envisaged to increase the relative yield of templated microcrystals. Firstly, the volume of mesoporous template could be increased to encompass the entire reaction volume, requiring in this case approximately 150 g of silica to fill 50 ml. Clearly this is an extremely inefficient use of the templating material. A second approach is to impose conditions under which crystal nucleation occurs preferentially (or exclusively) within the template pores, rather than elsewhere in the reaction vessel (solution bulk or vessel walls). To achieve this a predetermined number of preformed nanocrystals or nucleation sites were placed on the surface of the silica pores, that act as nucleation points for subsequent crystal growth. This also allows reaction conditions to be altered such that the rate of homogeneous nucleation is significantly reduced or completely eliminated (i.e. reduced temperature or precursor concentration).

A highly effective implementation of this principle for a silica template is to expose the template to an aqueous solution of TiCl₄ of sufficiently low concentration that isolated clusters of TiO₂ are formed on the surface. The final crystal size (volume) is inversely proportion to the number of TiO₂ nuclei since the growing product is shared approximately equally between the crystals which grow in parallel. Figure 2 illustrates that the number of nuclei, and therefore final crystal volume, is controllable via the concentration of TiCl₄ in the pretreatment phase. The series of reactions in Figure 2 was carried out under the same conditions as those in Figure 1 - i.e. homogeneous nucleation is still possible. A simple estimate of the ratio of seeded crystals to homogenously nucleated crystals is given by the inverse of ratio of the mean crystal volume, to that under the non-treated conditions (mean volume of 10 µm, Figure 1a). This ratio is approximately 10 with a 15 µm TiCl₄ treatment and 650 mg template.

Taking a 15 µm TiCl₄ pre-treatment for further experiments, Figure 5 shows the effect of reducing reaction temperature on the external dimensions of the mesoporous crystals after a fixed reaction time of 12 h. The decreasing size is caused by a progressively slower growth rate with decreasing temperature, such that the degree of conversion is reduced after a given reaction time. The aspect ratio of the truncated bipyramidal crystals (as defined in Figure 5b) also decreases with decreasing temperature.

Figure 3 shows the high fidelity mesoscale replication within faceted mesoporous single crystal anatase TiO₂. (a) Pristine silica template made up of quasi close-packed 50nm silica beads (FFT inset 49±3nm with hexagonal close-packed symmetry), (b) mesoscale pore structure at the (100) surface of TiO₂ crystals synthesized inside the template in (a) at 170°C, 40mM TiF₄ shows perfect replication of the template voids (FFT inset 47±3nm with hexagonal close-packed symmetry), (c) TiO₂ crystals that nucleate near the surface of the silica template continue to grow out of the confines of the pores, resulting in non-porous areas coexisting with porous areas within a single microcrystal. When this happens the single-domain nature of the microcrystal is evident as the compact-region growth front from distant pores meet and follow the faceted contours expected from the single underlying anatase crystal symmetry. Reaction conditions are (c) 210°C 20mM and (d) 170°C 20mM.

Figure 4 shows the mesoporous crystal morphology evolution with increasing volume of pre-treated silica template, (a) SEM images of representative truncated bipyramidal anatase TiO₂ microcrystals (after template removal) synthesized at 130°C 120 mM in 50 ml reaction vessels containing the stated mass of silica template (15 µM TiCl₄ template pretreatment). (b) Crystal size (A) distributions for the samples in (a).

Figure 5 shows the effect of reaction temperature on mesoporous crystal dimension (40 mM initial TiF₄ concentration), (a) Representative truncated bipyramidal anatase TiO₂ microcrystals (after template removal) synthesized at the stated reaction temperature for 12 h (15 µM TiCl4 template pretreatment). (b) Population distribution of microcrystal dimension size (A) as a function of reaction temperature, (c) Mean dimension (A) and aspect ratio of the populations in (b), the size distribution (standard deviation) becomes narrower with decreasing reaction temperature.

Figure 6 shows the morphological evolution of mesoporous TiO₂ microcrystals with time at 130°C (120 mM TiF₄). (a) Representative truncated bipyramidal anatase TiO₂ microcrystals (after template removal) after the stated reaction temperature (15 µM TiCl₄ template pretreatment). (b) Mass of TiO₂ crystals produced after time t.

Figure 7 shows the loss of mesoscale porosity in the TiO₂ mesoporous crystals caused by template etching, (a) Morphology of mesoporous TiO₂ microcrystals after 12 h reaction at 130°C with the stated initial TiF₄ concentration, (b) Morphology of the (50 nm silica bead) template corresponding to the reaction times in (a). Surface porosity of the crystals is noticeably degraded at TiF₄ concentrations above 80 mM under these conditions.

Figure 8 shows the degradation of the silica template with increasing reaction temperature, (a) Pristine template (quasi close-packed 50nm diameter silica beads), (b) After reaction at 100°C, 120mM TiF₄ for 62 h no significant change is visible in the bead structure, (c) After 12 h at 170°C, 120mM TiF₄ the template shows significant coarsening caused by HF etching of silica, (d) After 12 h at 210°C the coarsening is even more severe, even at low (20 mM) TiF₄ concentration (i.e. low concentration HF production).

Figure 9 shows the degradation of silica template with reaction time at 130°C, 120 mM initial TiF₄ concentration, (a) Pristine template (quasi close-packed 50 nm diameter silica beads), and the evolution of template structure after the stated reaction time in hours. (b) Normalised mass loss (M/Mo) of the templates in (a).

Figure 10 shows a Current-Voltage curve from the prototype solar cells made using active electrode layers formed from 50 nm silica bead-patterned mesoporous TiO₂ single crystals synthesized at 130°C from a 120 mM TiF₄ solution. The crystals were processed into a layer from a screen-printable paste containing a cellulose binder.. The electrodes were light-sensitized with a surface-adsorbed organic indolene dye before infiltration with an organic hole transporting material (spiro-ometad) and capped with a silver electrode.

Figure 11 shows the pore distribution of a pristine, quasi close-packed 30 nm diameter silica bead template (SEM inset) as determined by BET analysis of nitrogen adsorption-desorption isotherms. The surface area of the 30nm bead template is 277 m²g⁻¹, with a pore volume of 0.58 cm³g⁻¹ and pore distribution peak at approximately 15 nm.

Figure 12a is a schematic illustration of the removal of the template material by selective etching in NaOH (aq) to recover the mesoporous TiO₂ crystal product. SEM characterisation of the mesoporous TiO₂ crystal product (Figure 12d-g) reveals faceted truncated bipyramidal crystals with external symmetry matching that of the homogeneously nucleated bulk crystals (Figure 12c), whose mesoscale structure is a negative replica of the silica template. The crystal in Figure 12d is particularly instructive, since it evidently grew from a seed located on or close to an external surface of the mesoporous template. In one direction the crystal growth is directed outwards into the solution and results in a compact, faceted TiO₂ crystal with a symmetry consistent with the anatase TiO₂ Wulff construction. In the opposite direction the growth front enters the templated volume such that the crystal grows around the guiding template (mesoscale detail shown in Figure 12e). The single set of external crystal facets is strong evidence for the nucleation and growth mechanism of a single-crystal domain from a single nucleation site. Crystals grown entirely within the template pores (Figure 12f,g) also have external symmetry matching the Wulff construction, now coupled with an internal mesopority whose accessibility is confirmed by dye adsorption-desorption surface area measurements of 150 µm²µm⁻³ or, equivalently, 70 m²g⁻¹ for 20 nm pores in 2 µm³ crystals. That is, the specific free surface of these MSCs is very similar to equivalent sized nanoparticles (Dyesol DSL 18NR-T, 20 nm average particle size, 75m²g⁻¹).

### Preparation of mesoporous silica templates:

50 nm diameter silica spheres were synthesised according to Bogush et al. 32 ml H₂O (Millipore 18 M Omega), 18 ml ammonium hydroxide (30 %, Sigma Aldrich) and 99 ml tetraethyl orthosilicate (TEOS, Sigma Aldrich) were added to 750 ml ethanol a stirred at 700 rpm for 24 hours. An approximately close-packed sphere template was prepared by centrifugation (7000 rpm, 5 h) of the reaction solution leaving a translucent solid. The (unwashed) solid was sintered at 500 °C for 30 min (ramping time 150 min).

### Pre-treatment of Silica templates:

A TiCl₄(aq) solution was prepared by aqueous dilution of a 2M TiCl₄(aq) stock solution (stock preparation: 100 ml of TiCl₄ was added to 350 ml H₂O containing 1 mL of 35% HCl in an ice bath). 5 g of the sintered template was immersed in 33 ml of a 15 µM TiCl₄(aq) solution and held at 70 °C for 60 min followed by thorough rinsing with 11H₂O. The dried template was resintered at 500 °C for 30 min (ramping time 150 min).

### Synthesis of TᵢO₂:

Mesoporous TiO₂ crystals were synthesised hydrothermally using a modified version of the procedure reported by Zhang et al. Titanium tetrafluoride (TiF₄, Alfa Aesar) was dissolved in H₂O (concentrations from 20 mM to 400 mM) with pH adjusted to 2.1 by addition of 37% HCl (200 µl in 250 ml). 1.67 ml of the ionic liquid 1-methylimidazolium tetrafluoroborate, and 650 mg of the pre-treated silica template were added to 50 ml of TiF₄ solution in a 125 ml volume PTFE-lined autoclave (Parr Instruments). The sealed vessel was brought to the target reaction temperature (from 100 to 210 °C) in a fan-assisted oven and cooled in air. The template product was collected as a solid white powder at the base of the vessel and collected and rinsed with H₂O by vacuum filtration on 1.2 µm paper (Whatman). The silica was etched in a 2M NaOH(aq) at 80 °C for 60 min. The remaining TiO₂ was collected by centrifugation (4000 rpm, 60 min) and washed twice with 50 ml H₂O, and twice with 50 ml ethanol.

### Characterisation Methods:

Template and crystal-replica morphologies were investigated by SEM (Hitachi S-4300) at an accelerating voltage of 5 kV after platinum coating samples prepared by drop casting on glass substrates. TEM measurements were made with a Jeol2010 microscope operating at 200 kV. Surface area measurements were made by Brunauer, Emmett, Teller (BET) analysis of nitrogen adsorption-desorption isotherms (Sorptomatic 1990).

### Mesoporous crystal paste fabrication

The mesoporous TiO₂ single crystals were processed into a paste for layer-formation according to a modified version of the process reported by Ito et al. (Ito et al. Prog. Photovoltaics 2007, 15, 603). The paste contained (per gram of TiO₂): 167 µL of acetic acid, 833 µl deionised water, 3.33 g of alpha-terpineol and 5 g of a 10 wt% solution of ethyl-cellulose (1:1, 10cps:46 cps). The paste was mixed by stirring and unltrasonication, and excess ethanol removed by evaporation.

### Solar cell electrode fabrication:

FTO-coated glass sheets (15 Ω/sq Pilkington) were etched with zinc powder and HCl (2 M) to obtain the required electrode pattern. The sheets were then washed with soap (2% Hellmanex in water), deionized water, acetone, and methanol, and finally treated under oxygen plasma for 10 min. The substrates were subsequently coated with a compact layer of TiO₂ (100 nm) by aerosol spray pyrolysis deposition in air at 250°C. The mesoporous crystal TiO₂ paste, as described above, was screen printed onto the TiO₂ compact layer and sintered at 500°C (ramped over 1.5 h) for 30 min in air. After cooling, the layers were soaked in a 20 mM TiCl_{4(aq)} bath for 1 h at 70°C then rinsed with deionized water and dried in air. The layers were resintered at 500°C for 45 min in air, then cooled and submersed in an indolene dye solution (D102 [Schmidt-Mende et al. Adv. Matter. 2005, 17, 813.] 0.2 mM in a 1:1 volume ratio of tert-butanol and acetonitrile) for 1 h.

### Solar cell fabrication:

The hole transporting material used was spiro-OMeTAD which was first dissolved in chlorobenzene at 15%vol. After fully dissolving the spiro-MeOTAD at 100 °C for 30 minutes the solution was cooled and tertbutyl pyridine (*t*BP) was added directly to the solution with a volume to mass ratio of 1:26 µl/mg *t*BP:spiro-OMeTAD. Lithium bis(trifluoromethylsulfonyl)imide salt (Li-TFSI) ionic dopant was pre-dissolved in acetonitrile at 170 mg/ml, then added to the hole-transporter solution at 1:12 µl/mg of Li-TFSI solution:spiro-OMeTAD. The dyed films were rinsed briefly in acetonitrile and dried in air. The hole transporter and additives solution was deposited by spin coating at 700 rpm onto the dyed crystal layer in air. Silver electrodes (150nm) were deposited onto the surface of the dried layer under vacuum (10⁻⁶ mbar).

### Solar cell characterization:

AM 1.5 solar illumination was generated from an Abet Technologies Class AAB solar simulator with an AM 1.5 global filter. The intensity was calibrated with a calibrated silicon reference cell incorporating a KG5 filter in order to minimize the solar spectral mismatch factor when measuring the DSCs. The electronic measurements were taken with a Keithely 2400 sourcemeter interfaced to a PC. Opaque optical masks of approximately 0.12 cm⁻² were used to define the area of the solar cell.

### Example 2 - Further Characterisation of Mesoporous Single Crystals (MSCs)

The nature of the templated crystals was probed further at the atomic scale by X-ray diffraction (XRD) and electron diffraction (ED) shown in Figure 13. The XRD pattern of an ensemble of the mesoporous product is compared in Figure 13a to both a standard mesoporous anatase TiO₂ nanoparticle film (Dyesol DSL 18NR-T, 20 nm average particle size), and to nontemplated (solid) anatase microcrystals. All patterns index to the anatase phase of titania. The apparent average domain size of the conventional nanoparticle film calculated from Scherrer broadening of the primary (101) peak is 20 nm. The peak width of the TiO₂ crystals synthesized from the TiF₄ precursor is dramatically narrower, and is in fact now limited by the machine broadening of 0.08 FWHM. Importantly, the peak width of the mesoporous crystals, with 20 nm porosity, matches that of the non-templated anatase microcrystals, consistent with the porous particles being single crystalline domains; this correspondence is independent of pore size, consistent with a decoupling of crystallinity and surface area.

Electron diffraction taken from complete mesoporous particles produces the Laue diffraction patterns shown in Figure 13b-e that are indexed to anatase TiO₂ with beam orientation consistent with the crystal symmetry of the Wulff construction. The distinct crystal shapes in Figure 13b and d result from different reaction temperatures. Taken together with SEM characterisation of particle size and symmetry, these results are entirely consistent with the mesoporous particles comprising a single underlying anatase crystal domain, with missing internal volume defined by the mesoporous template - this material may therefore be referred to as a mesoporous single-crystal (MSC).

Returning to the question of seeding density, which can be used not only to increase the relative number of crystals that grow in the template, but also to control their size, since the seeded crystals grow in parallel, consuming all the available Ti precursor if the reaction is run to completion. Figure 14 shows how the number of TiO₂ seeds (N) and hence the average crystal volume (inversely proportional to N) can be varied over 4 orders of magnitude by varying the seeding solution concentration ([TiCl₄(aq)]) from 15 M to 15 mM. The Ti content in the seeded template, determined by inductively coupled plasma atomic emission spectroscopy (ICPOES), increases approximately linearly with [TiCl₄] in this range (ICPOES results and corresponding SEM images in Figure 15). This result demonstrates explicitly how the MSC domain size is decoupled from the internal pore dimension imposed by the template morphology.

Figure 15 shows the results of the Inductively coupled plasma optical emission spectroscopy (ICPOES) and SEM Characterisation of MSC seeding density dependence. The top panel shows the ratio of Ti to Si (wt/wt) in silica bead templates following seeding treatment at 70 °C for 60 min at a range of TiCl₄ (aq) concentrations. The bottom panel, a-d, are SEM images of seeded TiO₂ MSC morphologies over a range of (decreasing) crystal seeding conditions: 15; 1:5; 0:3; 0:015 mmol [TiCl₄(aq)]. Final hydrothermal reaction conditions were 210 °C, 12 h, 20mM TiF₄ in all cases (note change in scale).

### Example 3 - Independence of MSC crystal domain size and internal pore dimension

As an alternative to varying seed density, both MSC size and shape can be controlled via the TiF₄ hydrothermal reaction conditions. Reaction temperature, for example, influences both the aspect ratio and lateral size of the MSCs for a fixed template morphology, seed density, and reaction time. The internal mesopore size can be adjusted by replicating silica bead templates of different diameter (d), such that the surface area (m²g⁻¹) of the quasi close-packed templates is inversely proportional to d. MSC pore morphologies replicating bead diameters between 20 and 250 nm are shown in Figure 16. Control over the mesopore dimension is important not only in increasing specific surface area, but is also crucial for optimising diffusion of species through the pore structure in, for example, high efficiency SSCs containing viscous liquid electrolytes or solid-state hole-conductors and for long range ion diffusion in batteries.

Thus, TiO₂ MSCs were synthesized, in mesoporous templates comprising silica beads with average diameter ranging from 20nm to 200nm, from a TiF₄ precursor by hydrothermal growth at 120°C for 12 hours. XRD characterisation of the MSCs, alongside SEM images of the internal pore size is shown in Figure 16. The FWHM peak width of the primary diffraction (101) peak is identical (limited by machine resolution) in all cases. These XRD data confirm a lower limit of crystal domain size of at least 200nm for all samples (machine limit), consistent with atomic coherence that is not limited to the characteristic pore dimension within the single-crystal particles.

### Example 4 - Electronic properties

Having demonstrated a synthesis protocol for anatase TiO₂ MSCs with independently tunable crystal and pore size, it was investigated if the MSCs exhibited superior electronic properties in comparison to mesoporous films constructed from dried or sintered nanoparticles. First, electronic conductivity through an isolated MSC was measured and compared to that of TiO₂ nanoparticle films. Before and after annealing at 500 °C, the MSC exhibits conductivity just under three and two orders of magnitude higher, respectively, across a ∼500 nm electrode gap. The nanoparticle film conductivity increases far more upon sintering than does the MSC, rationalized by enhanced electronic contact through inter-particle neck growth between the nanoparticles; a process now less relevant to MSCs because of pre-existing long-range crystal order. Notably, the as-cast MSC is more conductive than the sintered nanoparticle film. The electronic mobility in MSC films was estimated using the following requisite technique which we the inventors have recently developed: "Transient Mobility Spectroscopy" (TMS). Briefly, the time-resolved conductivity and photoinduced charge absorption spectrum are measured simultaneously to extract the charge density and thus mobility. In this configuration, the electrode gap is approximately 100 µm, so the measured MSC mobility is an effective mobility including the influence of inter-particle boundaries. Despite this, the MSC films exhibit mobility values over an order of magnitude higher than the nanoparticle films over a broad range of charge densities (Figure 17).

### Example 5 - Presintering treatment of TiO₂ MSCs embedded in a mesoporous silica template

TiO₂ MSCs were synthesized in a silica template made up of 50nm beads from a TiF₄ precursor by hydrothermal growth at 120°C for 12 hours. The template containing embedded MSCs was then thermally sintered in air at temperatures ranging from 500°C to 850°C in a tube furnace. The heat-treated MSCs were freed by selective etching of the silica template in 2M NaOH at 80°C for 1 hour. And collected by centrifugation (4000 rpm, 60 min) and washed twice each in 50 mL water and 50 mL ethanol. Ethanol was removed until the composition of the solution was 1:10 w/w TiO₂: ethanol. The MSCs were incorporated into a paste for film deposition comprising 333mg of terpineol and 500mg of 1:10w/w ethyl cellulose : ethanol solution per 100mg of TiO₂.

The crystal phase of the heat-treated MSCs was characterized by XRD after template removal as shown in Figure 18. The pure anatase TiO₂ phase remains stable for all temperatures up to 850°C, well above the usually-observed anatase-rutile transition temperature of 500°C.

### Solid State Dye Sensitized Cell Fabrication

FTO-coated glass sheets (15Ωcm⁻¹ Pilkington) were etched with zinc powder and HCl (2M) to obtain the required electrode pattern. The sheets were then washed with soap (2% Hellmanex in water), deionized water, acetone, and methanol, and finally treated under oxygen plasma for 10min to remove the last traces of organic residues. The FTO sheets were subsequently coated with a compact layer of TiO₂ (100nm) by aerosol spray pyrolysis deposition at 250°C, using air as the carrier gas. Subsequently, MSC films were deposited. Films were fabricated by doctor blading the MSC paste onto the substrate using scotch tape to achieve uniform film thickness of, on average, 3 microns. Subsequently, the films were annealed at 500°C for 45 minutes. Films were then immersed in 15mM aqueous TiCl₄ solution for 60 minutes at 70°C, rinsed in water, and resintered at 500°C for 45 minutes.

Following resintering, films were cooled down to 70°C and finally submersed in a dye solution for 1h. The indolene dye used was D102, 0.2mM in a 1:1 volume ratio of tert-butanol and acetonitrile. Spiro-OMeTAD was dissolved in chlorobenzene at 10 vol%. After fully dissolving the hole transporter, 4-tert-butyl pyridine (tBP) was added with a volume-to-mass ratio of 1:26µL mg⁻¹ tBP : Spiro-OMeTAD. Lithium bis(trifluoromethylsulfonyl)imide salt (Li-TFSI) was predissolved in acetonitrile at 170mgmL⁻¹, then added to the hole transporter solution at 1:12µL mg⁻¹ of Li-TFSI solution : Spiro-OMeTAD. The dyed films were rinsed briefly in acetonitrile and dried in air for 1min. Then a small quantity of the hole transporter solution, 18-25µL, was spin-coated on the substrate at 1000rpm for 25s in air. The films were left for a minimum period of 4h in air before placing them in a thermal evaporator where 200nm thick silver electrodes were deposited through a shadow mask under high vacuum (10⁻⁶mbar). The active area of the devices was defined by a metal optical mask with 0.11cm² aperture.

### Solar Cell Performance and Characterization

Solid-state dye sensitized solar cells (SDSC) were fabricated with photoanodes comprised of TiO₂ MSCs. The performance characteristics under full sun illumination are summarized in Figure 19.

Transient photocurrent and photovoltage decay measurements in Figure 20(a) probe electronic charge transport in the MSC film ensembles. The transport rate through the ensemble increases with increasing pre-anneal temperature, while the measured injected charge density decreases. At full sun intensity, the product of charge density and transport rate constant is approximately equal for all four anneal temperatures. Figure 20(b) shows the dependence of open circuit voltage on light intensity. While all devices exhibit the same voltage under full sun intensity, devices with MSCs annealed at higher temperatures lose less voltage under low illumination, suggesting that the dark electron density is higher in devices annealed at high temperatures, since electron density is exponentially related to the TiO₂ Fermi level.

Transient Mobility Spectroscopy (TMS) simultaneously monitors charge density, via transient absorption spectroscopy of the excited dye cation, and lateral conductivity in pre-annealed MSC films with a surface-adsorbed dye sensitizer. The resulting mobility values for 500°C and 850°C preannealed MSCs are plotted in Figure 21 for a range of charge densities. The MSC film annealed at 850°C exhibits a higher effective mobility than that annealed at 500°C by about an order of magnitude at low charge densities. The TMS results offer strong evidence reinforcing the hypothesis that increased background charge density in the MSCs annealed at higher temperature increases the electronic transport rate.

## Claims

1. A process for producing a mesoporous single crystal of a semiconductor, wherein the shortest external dimension of said single crystal, measured along any of the crystallographic principal axes of said crystal, is x, wherein x is equal to or greater than 50 nm, which process comprises:
providing a mesoporous template material, the mesoporous template material comprising a material comprising pores;
producing a seeded mesoporous template material which comprises a seed crystal of the semiconductor disposed in a pore of the mesoporous template material, by growing said seed crystal in the mesoporous template material; and
subsequently growing a single crystal of the semiconductor within the seeded mesoporous template material until said shortest external dimension of the single crystal is x.

2. A process according to claim 1 wherein the volume of said single crystal is y, wherein y is equal to or greater than 1.25x10⁵ nm³, and wherein the process comprises growing said single crystal within the mesoporous template material until the volume of said single crystal is y.

3. A process according to claim 1 or claim 2 wherein the mesoporous template material comprises a mesoporous inorganic material or a mesoporous carbon-based material.

4. A process according to any one of the preceding claims wherein the volume of the seed crystal is less than or equal to 1000 nm³.

5. A process according to any one of the preceding claims wherein the seeded mesoporous template material comprises a plurality of said seed crystals of said semiconductor.

6. A process according to any one of the preceding claims wherein:
(i) the mesoporous template material has a porosity of from 10 % to 70 %; and
(ii) the mean pore size of the pores in the mesoporous template material is from 1 nm to 1000 nm.

7. A process according to any one of the preceding claims wherein the semiconductor comprises: an oxide or chalcogenide of a metal or metalloid element; a group IV compound; a compound comprising a group III element and a group V element; a compound comprising a group II element and a group VI element; a compound comprising a group I element and a group VII element; a compound comprising a group IV element and a group VI element; a compound comprising a group V element and a group VI element; a compound comprising a group II element and a group V element; or a ternary or quaternary compound semiconductor.

8. A process according to any one of claims 1 to 7 wherein the semiconductor comprises an oxide or chalcogenide of a metal or metalloid element.

9. A process according to claim 8 wherein the semiconductor comprises an oxide of titanium, niobium, tin, zinc, cadmium, copper or lead or a mixed oxide of any combination of one or more of said metals; a chalcogenide of antimony, bismuth or cadmium or a mixed chalcogenide of any combination of one or more of said metals; zinc tin oxide; copper zinc tin sulphide; copper indium gallium selenide, or copper indium gallium diselenide.

10. A process according to claim 8 or claim 9 wherein said growing a single crystal of the semiconductor within the seeded mesoporous template material comprises contacting a crystal growing solution with the seeded mesoporous template material, wherein the crystal growing solution comprises a salt of said metal or metalloid element dissolved in a solvent.

11. A process according to claim 10 wherein said salt of said metal or metalloid element is:
(a) a salt which is a precursor to said oxide or chalcogenide of said metal or metalloid element, or
(b) said oxide or chalcogenide of said metal or metalloid element, or
(c) a halide, a sulphide, an oxysulphide or an alkoxide of said metal or metalloid element.

12. A process according to claim 10 or claim 11 wherein the semiconductor comprises an oxide of a metal or metalloid element, and wherein said salt of said metal or metalloid element is a salt which is hydrolysable to produce said oxide.

13. A process according to any one of claims 10 to 12 wherein said contacting comprises:
(a) contacting the crystal growing solution with the seeded mesoporous template material in the presence of an ionic liquid; or
(b) contacting the crystal growing solution with the seeded mesoporous template material at a crystal growing temperature, which is ambient temperature or an elevated temperature, and optionally:
(i) contacting the crystal growing solution with the seeded mesoporous template material at said crystal growing temperature for at least 30 minutes; and
(ii) cooling the crystal growing solution and the seeded mesoporous template material.

14. A process according any one of the preceding claims wherein said mesoporous template material is present in the form of:
(i) a solid powder or monolith; or
(ii) a layer disposed on a substrate, which substrate is suitable for use in a semiconducting device.

15. A process according to any one of the preceding claims which further comprises heating the single crystal thus produced at an elevated temperature, whilst in the template material.

16. A process according to any one of the preceding claims which further comprises recovering the mesoporous single crystal thus produced, wherein said recovering comprises removing the mesoporous template material from around and within the mesoporous single crystal.

17. A process according to any one of the preceding claims wherein:
(i) x is equal to or greater than 100 nm; or
(ii) the process is as defined in claim 2 and y is equal to or greater than 1,000,000 nm³.

18. A process according to any one of the preceding claims wherein the semiconductor is as defined in any one of claims 7 to 9 and wherein said growing said seed crystal comprises contacting a seed crystal growing solution with said mesoporous template material, wherein the seed crystal growing solution comprises a salt of said metal or metalloid element dissolved in a solvent.

19. A process according to claim 18 which further comprises recovering the seeded mesoporous template material from the seed crystal growing solution.

20. A process according to claim 18 or claim 19 wherein said contacting comprises contacting said seed crystal growing solution with said mesoporous template material at a seed crystal growing temperature, which is ambient temperature or an elevated temperature.

21. A process according to claim 20, further comprising re-sintering the seeded mesoporous template material thus produced, by heating the seeded mesoporous template material to a temperature suitable for sintering.

22. A mesoporous single crystal of a semiconductor, wherein the shortest external dimension of said single crystal, measured along any of the crystallographic principal axes of said crystal, is x, wherein x is equal to or greater than 50 nm.

23. A mesoporous single crystal according to claim 22 wherein:
(i) the volume of said single crystal is equal to or greater than 1.25x10⁵ nm³;
(ii) the mesoporous single crystal has a porosity of equal to or greater than 30 %;
(iii) the mean pore size of the pores within said mesoporous single crystal is equal to or greater than 5 nm;
(iv) the mesoporous single crystal has an aspect ratio which is greater than or equal to 2; or
(v) the mesoporous single crystal has a surface area equal to or greater than 25 m²/g.

24. A mesoporous single crystal according to claim 22 or claim 23 wherein the semiconductor comprises an oxide or chalcogenide of a metal or metalloid element; a group IV compound; a compound comprising a group III element and a group V element; a compound comprising a group II element and a group VI element; a compound comprising a group I element and a group VII element; a compound comprising a group IV element and a group VI element; a compound comprising a group V element and a group VI element; a compound comprising a group II element and a group V element; or a ternary or quaternary compound semiconductor.

25. A composition or semiconducting layer which comprises a plurality of mesoporous single crystals as defined in any one of claims 22 to 24.

26. A semiconducting device which comprises at least one layer that comprises a mesoporous single crystal as defined in any one of claims 22 to 24.

27. A semiconducting device according to claim 26 which is a photovoltaic device, a photodiode, a solar cell, a photo detector, a light-sensitive transistor, a phototransistor, a solid- state triode, a battery electrode, a light-emitting device or a light-emitting diode.

## Patentansprüche

1. Verfahren zum Herstellen eines mesoporösen Einkristalls eines Halbleiters, wobei die kürzeste äußere Abmessung des Einkristalls, gemessen entlang einer der kristallographischen Hauptachsen des Kristalls, x ist, wobei x gleich wie oder größer als 50 nm ist, wobei das Verfahren Folgendes umfasst:
Bereitstellen eines mesoporösen Vorlagenmaterials, wobei das mesoporöse Vorlagenmaterial ein Material umfassend Poren umfasst;
Herstellen eines geimpften mesoporösen Vorlagenmaterials, das einen Impfkristall des Halbleiters umfasst, der in einer Pore des mesoporösen Vorlagenmaterials angeordnet ist, wesentliches Züchten des Impfkristalls in dem mesoporösen Vorlagenmaterial; und
anschließendes Züchten eines Einkristalls des Halbleiters innerhalb des geimpften mesoporösen Vorlagenmaterials, bis die kürzeste äußere Abmessung des Einkristalls x ist.

2. Verfahren nach Anspruch 1, wobei das Volumen des Einkristalls y ist, wobei y gleich wie oder größer als 1,25 x 10⁵ nm³ ist, und wobei das Verfahren ein Züchten des Einkristalls in dem mesoporösen Vorlagenmaterial umfasst, bis das Volumen des Einkristalls y ist.

3. Verfahren nach Anspruch 1 oder Anspruch 2, wobei das mesoporöse Vorlagenmaterial ein mesoporöses anorganisches Material oder ein mesoporöses kohlenstoffbasiertes Material umfasst.

4. Verfahren nach einem der vorherigen Ansprüche, wobei das Volumen des Impfkristalls kleiner als oder gleich wie 1000 nm³ ist.

5. Verfahren nach einem der vorhergehenden Ansprüche, wobei das geimpfte mesoporöse Vorlagenmaterial eine Vielzahl der Impfkristalle des Halbleiters umfasst.

6. Verfahren nach einem der vorherigen Ansprüche, wobei:
i) das mesoporöse Vorlagenmaterial eine Porosität von 10 % bis 70 % aufweist; und
(ii) die mittlere Porengröße der Poren in dem mesoporösen Vorlagenmaterial von 1 nm bis 1000 nm beträgt.

7. Verfahren nach einem der vorherigen Ansprüche, wobei der Halbleiter Folgendes umfasst: ein Oxid oder Chalkogenid eines Metallelements oder metallartigen Elements; eine Verbindung der Gruppe IV; eine Verbindung, die ein Element der Gruppe III und ein Element der Gruppe V umfasst; eine Verbindung, die ein Element der Gruppe II und ein Element der Gruppe VI umfasst; eine Verbindung, die ein Element der Gruppe I und ein Element der Gruppe VII umfasst; eine Verbindung, die ein Element der Gruppe IV und ein Element der Gruppe VI umfasst; eine Verbindung, die ein Element der Gruppe V und ein Element der Gruppe VI umfasst; eine Verbindung, die ein Element der Gruppe II und ein Element der Gruppe V umfasst; oder einen ternären oder quaternären Verbindungshalbleiter.

8. Verfahren nach einem der Ansprüche 1 bis 7, wobei der Halbleiter ein Oxid oder Chalkogenid eines Metallelements oder metallartigen Elements umfasst.

9. Verfahren nach Anspruch 8, wobei der Halbleiter ein Oxid von Titan, Niob, Zinn, Zink, Cadmium, Kupfer oder Blei oder ein Mischoxid einer beliebigen Kombination von einem oder mehreren der Metalle; ein Chalkogenid von Antimon, Wismut oder Cadmium oder ein gemischtes Chalkogenid einer beliebigen Kombination von einem oder mehreren der Metalle; Zinkzinnoxid; Kupferzinnsulfid; Kupferindiumgalliumselenid oder Kupferindiumgalliumdiselenid umfasst.

10. Verfahren nach Anspruch 8 oder Anspruch 9, wobei ein Züchten eines Einkristalls des Halbleiters in dem gekeimten mesoporösen Vorlagenmaterial ein Inkontaktbringen einer Kristallzüchtungslösung mit dem geimpften mesoporösen Vorlagenmaterial umfasst, wobei die Kristallzüchtungslösung ein Salz des Metallelements oder metallartigen Elements umfasst, das in einem Lösungsmittel gelöst ist.

11. Verfahren nach Anspruch 10, wobei das Salz des Metallelements oder metallartigen Elements wie folgt ist:
(a) ein Salz, das ein Vorläufer des Oxids oder Chalkogenids des Metallelements oder metallartigen Elements ist, oder
(b) das Oxid oder Chalkogenid des Metallelements oder metallartigen Elements, oder
(c) ein Halogenid, ein Sulfid, ein Oxysulfid oder ein Alkoxid des Metallelements oder metallartigen Elements.

12. Verfahren nach Anspruch 10 oder Anspruch 11, wobei der Halbleiter ein Oxid eines Metallelements oder metallartigen Elements umfasst, und wobei das Salz des Metallelements oder metallartigen Elements ein Salz ist, das hydrolysierbar ist, um das Oxid herzustellen.

13. Verfahren nach einem der Ansprüche 10 bis 12, wobei das Inkontaktbringen Folgendes umfasst:
(a) Inkontaktbringen der Kristallzüchtungslösung mit dem geimpften mesoporösen Vorlagenmaterial in der Anwesenheit einer ionischen Flüssigkeit; oder
(b) Inkontaktbringen der Kristallzüchtungslösung mit dem geimpften mesoporösen Vorlagenmaterial bei einer Kristallzüchtungstemperatur, die Umgebungstemperatur oder eine erhöhte Temperatur ist, und optional:
(i) Inkontaktbringen der Kristallzüchtungslösung mit dem geimpften mesoporösen Vorlagenmaterial bei der Kristallzuchttemperatur über mindestens 30 Minuten; und
(ii) Abkühlen der Kristallzüchtungslösung und des geimpften mesoporösen Vorlagenmaterials.

14. Verfahren nach einem der vorhergehenden Ansprüche, wobei das mesoporöse Vorlagenmaterial in der folgenden Form vorhanden ist:
(i) eines festen Pulvers oder Monolithen; oder
(ii) einer Schicht, die auf einem Substrat angeordnet ist, wobei das Substrat zur Verwendung in einer halbleitenden Vorrichtung geeignet ist.

15. Verfahren nach einem der vorherigen Ansprüche, das ferner ein Erwärmen des so hergestellten Einkristalls auf eine erhöhte Temperatur umfasst, während es im Vorlagenmaterial ist.

16. Verfahren nach einem der vorhergehenden Ansprüche, das ferner ein Gewinnen des so hergestellten mesoporösen Einkristalls umfasst, wobei das Gewinnen die Entfernung des mesoporösen Vorlagenmaterials aus der Umgebung und innerhalb des mesoporösen Einkristalls umfasst.

17. Verfahren nach einem der vorherigen Ansprüche, wobei:
(i) x gleich wie oder größer als 100 nm ist; oder
(ii) das Verfahren wie in Anspruch 2 definiert ist und y gleich wie oder größer als 1.000.000 nm³ ist.

18. Verfahren nach einem der vorherigen Ansprüche, wobei der Halbleiter wie in einem der Ansprüche 7 bis 9 definiert ist, und wobei das Züchten des Impfkristalls ein Inkontaktbringen einer Impfkristallzüchtungslösung mit dem mesoporösen Vorlagenmaterial umfasst, wobei die Impfkristallzüchtungslösung ein Salz des Metallelements oder metallartigen Elements umfasst, das in einem Lösungsmittel gelöst ist.

19. Verfahren nach Anspruch 18, das ferner ein Gewinnen des geimpften mesoporösen Vorlagenmaterials aus der Impfkristallzüchtungslösung umfasst.

20. Verfahren nach Anspruch 18 oder 19, wobei das Inkontaktbringen ein Inkontaktbringen der Impfkristallzüchtungslösung mit dem mesoporösen Vorlagenmaterial bei einer Impfkristallzüchtungstemperatur, die Umgebungstemperatur oder eine erhöhte Temperatur ist, umfasst.

21. Verfahren nach Anspruch 20, ferner umfassend ein erneutes Sintern des so hergestellten geimpften mesoporösen Vorlagenmaterials durch Erwärmen des geimpften mesoporösen Vorlagenmaterials auf eine zum Sintern geeignete Temperatur.

22. Mesoporöser Einkristall eines Halbleiters, wobei die kürzeste äußere Abmessung des Einkristalls, gemessen entlang einer der kristallographischen Hauptachsen des Kristalls, x ist, wobei x gleich wie oder größer als 50 nm ist.

23. Mesoporöser Einkristall nach Anspruch 22, wobei:
(i) das Volumen des Einkristalls gleich wie oder größer als 1,25x10⁵ nm³ ist;
(ii) der mesoporöse Einkristall eine Porosität von mindestens 30 % aufweist;
(iii) die mittlere Porengröße der Poren in dem mesoporösen Einkristall gleich wie oder größer als 5 nm ist;
(iv) der mesoporöse Einkristall ein Seitenverhältnis aufweist, das größer als oder gleich wie 2 ist; oder
(v) der mesoporöse Einkristall eine Oberfläche gleich wie oder größer als 25 m²/g aufweist.

24. Mesoporöser Einkristall nach Anspruch 22 oder Anspruch 23, wobei der Halbleiter ein Oxid oder Chalkogenid eines Metallelements oder metallartigen Elements; eine Verbindung der Gruppe IV; eine Verbindung, die ein Element der Gruppe III und ein Element der Gruppe V umfasst; eine Verbindung, die ein Element der Gruppe II und ein Element der Gruppe VI umfasst; eine Verbindung, die ein Element der Gruppe I und ein Element der Gruppe VII umfasst; eine Verbindung, die ein Element der Gruppe IV und ein Element der Gruppe VI umfasst; eine Verbindung, die ein Element der Gruppe V und ein Element der Gruppe VI umfasst; eine Verbindung, die ein Element der Gruppe II und ein Element der Gruppe V umfasst; oder einen ternären oder quaternären Verbindungshalbleiter umfasst.

25. Zusammensetzung oder halbleitende Schicht, die eine Vielzahl von mesoporösen Einkristallen umfasst, wie sie in einem der Ansprüche 22 bis 24 definiert sind.

26. Halbleitervorrichtung, die mindestens eine Schicht umfasst, die einen mesoporösen Einkristall umfasst, wie er in einem der Ansprüche 22 bis 24 definiert ist.

27. Halbleitervorrichtung nach Anspruch 26, die eine photovoltaische Vorrichtung, eine Fotodiode, eine Solarzelle, ein Photodetektor, ein lichtempfindlicher Transistor, ein Fototransistor, eine Festkörpertriode, eine Batterieelektrode, eine lichtemittierende Vorrichtung oder eine lichtemittierende Diode ist.

## Revendications

1. Processus de production d'un monocristal mésoporeux d'un semi-conducteur, dans lequel la dimension externe la plus courte dudit monocristal, mesurée le long de tout axe principal cristallographique, est x, x étant supérieur ou égal à 50 nm, le processus comprenant :
la fourniture d'un matériau type mésoporeux, le matériau type mésoporeux comprenant un matériau comprenant des pores ;
la production d'un matériau type mésoporeux amorcé qui comprend un germe du semi-conducteur disposé dans un pore du matériau type mésoporeux faisant croître matériellement ledit germe dans le matériau type mésoporeux ; et
la croissance ultérieure d'un monocristal du semi-conducteur dans le matériau type mésoporeux amorcé jusqu'à ce que la dimension externe la plus courte du monocristal atteigne x.

2. Processus selon la revendication 1, dans lequel le volume dudit monocristal est y, y étant supérieur ou égal à 1,25x10⁵ nm³, et le processus comprenant la croissance dudit monocristal dans le matériau type mésoporeux jusqu'à ce que le volume dudit monocristal atteigne y.

3. Processus selon la revendication 1 ou la revendication 2, dans lequel le matériau type mésoporeux comprend un matériau inorganique mésoporeux ou un matériau à base de carbone mésoporeux.

4. Processus selon l'une quelconque des revendications précédentes, dans lequel le volume du cristal amorcé est inférieur ou égal à 1000 nm³.

5. Processus selon l'une quelconque des revendications précédentes, dans lequel le matériau type mésoporeux amorcé comprend une pluralité desdits germes dudit semi-conducteur.

6. Processus selon l'une quelconque des revendications précédentes, dans lequel :
(i) le matériau type mésoporeux présente une porosité de 10 % à 70 % ; et
(ii) la taille moyenne de pore des pores dans le matériau type mésoporeux est de 1 nm à 1000 nm.

7. Processus selon l'une quelconque des revendications précédentes, dans lequel le semi-conducteur comprend : un oxyde ou chalcogénure d'un métal ou élément métalloïde ; un composé du groupe IV ; un composé comprenant un élément du groupe III et un élément du groupe V ; un composé comprenant un élément du groupe II et un élément du groupe VI ; un composé comprenant un élément de groupe I et un élément du groupe VII ; un composé comprenant un élément du groupe IV et un élément du groupe VI ; un composé comprenant un élément du groupe V et un élément du groupe VI ; un composé comprenant un élément du groupe II et un élément du groupe V ; ou un semi-conducteur composé ternaire ou quaternaire.

8. Processus selon l'une quelconque des revendications 1 à 7, dans lequel le semi-conducteur comprend un oxyde ou chalcogénure d'un métal ou élément métalloïde.

9. Processus selon la revendication 8, dans lequel le semi-conducteur comprend un oxyde de titane, de niobium, d'étain, de zinc, de cadmium, de cuivre ou de plomb ou un oxyde mixte d'une combinaison quelconque d'au moins desdits métaux ; un chalcogénure d'antimoine, de bismuth ou de cadmium ou un chalcogénure mixte d'une combinaison quelconque desdits métaux ; de l'oxyde de zinc-étain ; du sulfure de cuivre-zinc-étain ; du séléniure de cuivre-indium-gallium ou du diséléniure de cuivre-indium-gallium.

10. Processus selon la revendication 8 ou la revendication 9, dans lequel ladite croissance d'un monocristal du semi-conducteur dans le matériau type mésoporeux amorcé comprend la mise en contact d'une solution de croissance de cristal avec le matériau type mésoporeux amorcé, la solution de croissance de cristal comprenant un sel dudit métal ou élément métalloïde dissous dans un solvant.

11. Processus selon la revendication 10, dans lequel ledit sel de métal ou élément métalloïde est :
(a) un sel qui est un précurseur dudit oxyde ou chalcogénure dudit métal ou élément métalloïde, ou
(b) ledit oxyde ou chalcogénure dudit métal ou élément métalloïde, ou
(c) un halogénure, un sulfure, un oxysulfure ou un alcoxyde dudit métal ou élément métalloïde.

12. Processus selon la revendication 10 ou la revendication 11, dans lequel le semi-conducteur comprend un oxyde de métal ou élément métalloïde, et dans lequel ledit sel dudit métal ou élément métalloïde est un sel qui peut être hydrolysé pour produire ledit oxyde.

13. Processus selon l'une quelconque des revendications 10 à 12, dans lequel ladite mise en contact comprend :
(a) la mise en contact de la solution de croissance de cristal avec le matériau type mésoporeux amorcé en présence d'un liquide ionique ; ou
(b) la mise en contact de la solution de croissance de cristal avec le matériau type mésoporeux amorcé à une température de croissance de cristal, qui est la température ambiante ou une température élevée, et éventuellement :
(i) la mise en contact de la solution de croissance de cristal avec le matériau type mésoporeux amorcé à ladite température de croissance de cristal pendant au moins 30 minutes ; et
(ii) le refroidissement de la solution de croissance de cristal et du matériau type mésoporeux amorcé.

14. Processus selon l'une quelconque des revendications précédentes, dans lequel ledit matériau type mésoporeux est présent sous la forme :
(i) d'une poudre solide ou d'un monolithe ; ou
(ii) d'une couche disposée sur un substrat, le substrat étant approprié pour une utilisation dans un dispositif semi-conducteur.

15. Processus selon l'une quelconque des revendications précédentes, qui comprend en outre le chauffage du monocristal ainsi produit à une température élevée, tandis qu'il se trouve dans le matériau type.

16. Processus selon l'une quelconque des revendications précédentes, qui comprend en outre la récupération du monocristal mésoporeux ainsi produit, ladite récupération comprenant l'élimination du matériau type mésoporeux du voisinage et d'intérieur du monocristal mésoporeux.

17. Processus selon l'une quelconque des revendications précédentes, dans lequel :
(i) x est supérieur ou égal à 100 nm ; ou
(ii) le processus est tel que défini dans la revendication 2 et y est supérieur ou égal à 1 000 000 nm³.

18. Processus selon l'une quelconque des revendications précédentes, dans lequel le semi-conducteur est tel que défini dans l'une quelconque des revendications 7 à 9, ladite croissance dudit germe comprenant la mise en contact d'une solution de croissance de germe avec ledit matériau type mésoporeux, la solution de croissance de germe comprenant un sel dudit métal ou élément métalloïde dissous dans un solvant.

19. Processus selon la revendication 18, qui comprend en outre la récupération du matériau type mésoporeux amorcé depuis la solution de croissance de germe.

20. Processus selon la revendication 18 ou la revendication 19, dans lequel ladite mise en contact comprend la mise en contact de ladite solution de croissance de germe avec ledit matériau type mésoporeux à une température de croissance de germe, qui est la température ambiante ou une température élevée.

21. Processus selon la revendication 20, comprenant en outre un nouveau frittage du matériau type mésoporeux amorcé ainsi produit, par le chauffage du matériau type mésoporeux amorcé à une température appropriée pour un frittage.

22. Monocristal mésoporeux d'un semi-conducteur, la dimension externe la plus courte dudit monocristal, mesurée le long de tout axe principal cristallographique, étant x, x étant supérieur ou égal à 50 nm.

23. Monocristal mésoporeux selon la revendication 22 dans lequel :
(i) le volume dudit monocristal est supérieur ou égal à 1,25x10⁵ nm³ ;
(ii) le monocristal mésoporeux présente une porosité supérieure ou égale à 30 % ;
(iii) la taille moyenne de pore des pores dans ledit monocristal mésoporeux est supérieure ou égale à 5 nm ;
(iv) le monocristal mésoporeux présente un facteur de forme qui est supérieur ou égal à 2 ; ou
(v) le monocristal mésoporeux présente une aire spécifique supérieure ou égale à 25 m²/g.

24. Monocristal mésoporeux selon la revendication 22 ou la revendication 23, dans lequel le semi-conducteur comprend : un oxyde ou chalcogénure d'un métal ou élément métalloïde ; un composé du groupe IV ; un composé comprenant un élément du groupe III et un élément du groupe V ; un composé comprenant un élément du groupe II et un élément du groupe VI ; un composé comprenant un élément de groupe I et un élément du groupe VII ; un composé comprenant un élément du groupe IV et un élément du groupe VI ; un composé comprenant un élément du groupe V et un élément du groupe VI ; un composé comprenant un élément du groupe II et un élément du groupe V ; ou un semi-conducteur composé ternaire ou quaternaire.

25. Composition ou couche semi-conductrice qui comprend une pluralité de monocristaux mésoporeux tels que définis dans l'une quelconque des revendications 22 à 24.

26. Dispositif semi-conducteur qui comprend au moins une couche qui comprend un monocristal mésoporeux tel que défini dans l'une quelconque des revendications 22 à 24.

27. Dispositif semi-conducteur selon la revendication 26, qui est un dispositif photovoltaïque, une photodiode, une pile solaire, un photodétecteur, un transistor photosensible, un phototransistor, une triode à semi-conducteur, une électrode de batterie, un dispositif électroluminescent ou une diode électroluminescente.
